# EUROPEAN PATENT APPLICATION

(11) **EP 4 712 716 A1**
(43) Date of publication of application: **18.03.2026**
(21) Application number: 25186348.6
(22) Date of filing: 30.06.2025
(51) Int. Cl.: H10B 12/00

(54) **SEMICONDUCTOR DEVICE**

(30) Priority: 13.09.2024 KR 20240125773
(71) Applicant: Samsung Electronics Co., Ltd., Suwon-si, Gyeonggi-do 16677 (KR)
(72) Inventor: CHOI, Jin Myung, 16677 Suwon-si (KR); AHN, Dongho, 16677 Suwon-si (KR); YOON, Minseo, 16677 Suwon-si (KR); LEE, Jinwoo, 16677 Suwon-si (KR)
(74) Representative: Marks & Clerk LLP

(57) **Abstract**

A semiconductor device includes a bit line extending in a first direction, a mold structure extending in a second direction and having a first side surface and a second side surface opposed to each other in the first direction, and a first vertical semiconductor pattern and a second vertical semiconductor pattern that are on the bit line and are respectively on the first side surface and the second side surface of the mold structure. Each of the first side surface and the second side surface of the mold structure has a nonlinear portion, and the first vertical semiconductor pattern extends along the nonlinear portion of the first side surface, and the second vertical semiconductor pattern extends along the nonlinear portion of the second side surface.

## Description

### TECHNICAL FIELD

The present disclosure herein relates to a semiconductor device and a method for manufacturing the same, and more particularly, to a semiconductor memory device including vertical channel transistors and a method for manufacturing the same.

### BACKGROUND

A semiconductor device may include an integrated circuit composed of metal-oxide-semiconductor field effect transistors (MOSFET). As a size and a design rule of the semiconductor device are gradually decreasing, scaling down of the metal-oxide-semiconductor field effect transistors is also gradually being accelerated. As the metal-oxide-semiconductor field effect transistors are gradually scaled down, operation characteristics of the semiconductor device may deteriorate or be inhibited. Accordingly, research on various methods for overcoming limitations caused by high-integration of the semiconductor device and forming the semiconductor device with improved performance is being conducted.

### SUMMARY

The present disclosure provides a semiconductor device including vertical channel transistors having an increased channel width and a method for manufacturing the same.

The present disclosure also provides a semiconductor device including vertical channel transistors with improved electrical characteristics and a method for manufacturing the same.

An embodiment of the present disclosure provides a semiconductor device comprising bit lines on a substrate, extending in a first direction, and spaced apart from each other in a second direction, the first direction and the second direction being parallel to an upper surface of the substrate and crossing each other e.g. the first direction and the second direction may be parallel to the upper surface of the substrate and may be different and/or perpendicular to one another. The semiconductor device may include an insulating pattern between the bit lines and extending in the first direction. The semiconductor device may include a mold structure on the bit lines and the insulating pattern, extending in the second direction, and including a first part at least partially overlapping each of the bit lines in a third direction perpendicular to the upper surface of the substrate and a second part at least partially overlapping the insulating pattern in the third direction. The semiconductor device may include a first vertical semiconductor pattern and a second vertical semiconductor pattern on the bit lines and spaced apart from each other in the first direction, the first part of the mold structure between the first vertical semiconductor pattern and the second vertical semiconductor pattern. The semiconductor device may include a first gate electrode and a second gate electrode spaced apart from each other in the first direction with the mold structure therebetween, the first gate electrode and the second gate electrode extending in the second direction and on the bit lines and the insulating pattern. The first vertical semiconductor pattern is between the first gate electrode and the mold structure, the second vertical semiconductor pattern is between the second gate electrode and the mold structure, and a first width in the first direction of the first part of the mold structure is different from a second width in the first direction of the second part of the mold structure.

In an embodiment of the present disclosure, a semiconductor device includes a bit line extending on a substrate in a first direction and a mold structure extending on the bit line in a second direction, the first direction and the second direction being parallel to an upper surface of the substrate and crossing each other e.g. the first direction and the second direction may be parallel to the upper surface of the substrate and may be different and/or perpendicular to one another. The semiconductor device may include a first vertical semiconductor pattern and a second vertical semiconductor pattern on the bit line and spaced apart from each other in the first direction, the mold structure between the first vertical semiconductor pattern and the second vertical semiconductor pattern. The mold structure includes a first part having a first width in the first direction and a second part having a second width in the first direction, the second width different from the first width, and the first part of the mold structure that at least partially overlaps the bit line in a third direction that is perpendicular to the upper surface of the substrate and is between the first vertical semiconductor pattern and the second vertical semiconductor pattern.

In an embodiment of the present disclosure, a semiconductor device includes a bit line extending on a substrate in a first direction and a mold structure extending on the bit line in a second direction and including a first side surface and a second side surface opposed to each other in the first direction, the first direction and the second direction being parallel to an upper surface of the substrate and crossing each other e.g. the first direction and the second direction may be parallel to the upper surface of the substrate and may be different and/or perpendicular to one another. The semiconductor device may include a first vertical semiconductor pattern and a second vertical semiconductor pattern that are on the bit line and are respectively on the first side surface and the second side surface of the mold structure. Each of the first side surface and the second side surface of the mold structure includes a nonlinear portion, the first vertical semiconductor pattern extends along the nonlinear portion of the first side surface, and the second vertical semiconductor pattern extends along the nonlinear portion of the second side surface.

At least some of the above and other features of the invention are set out in the claims.

### BRIEF DESCRIPTION OF THE FIGURES

The accompanying drawings are included to provide a further understanding of the present disclosure, and are incorporated in and constitute a part of this specification. The drawings illustrate embodiments of the present disclosure and, together with the description, serve to explain principles of the present disclosure. In the drawings:
FIG. 1 is a block diagram illustrating a semiconductor device according to some embodiments of the present disclosure;
FIGS. 2 and 3 are respectively perspective views schematically illustrating a semiconductor device according to some embodiments of the present disclosure;
FIG. 4 is a plan view of a semiconductor device according to some embodiments of the present disclosure;
FIG. 5 is a cross-sectional view taken along A-A' of FIG. 4, and FIG. 6 is a cross-sectional view taken along B-B' of FIG. 4;
FIGS. 7, 10, 13 and 16 are plan views illustrating a method for manufacturing a semiconductor device according to some embodiments of the present disclosure;
FIGS. 8, 9, 11, 12, 14, 15, 17, 18, 19, 20, 21 and 22 are cross-sectional views illustrating a method for manufacturing a semiconductor device according to some embodiments of the present disclosure;
FIG. 23 is a plan view of a semiconductor device according to some embodiments of the present disclosure;
FIG. 24 is a cross-sectional view taken along A-A' of FIG. 23, and FIG. 25 is a cross-sectional view taken along B-B' of FIG. 23;
FIGS. 26 and 29 are plan views illustrating a method for manufacturing a semiconductor device according to some embodiments of the present disclosure;
FIGS. 27, 28, 30 and 31 are cross-sectional views illustrating a method for manufacturing a semiconductor device according to some embodiments of the present disclosure;
FIG. 32 is a plan view of a semiconductor device according to some embodiments of the present disclosure;
FIGS. 33 and 34 are plan views illustrating a method for manufacturing a semiconductor device according to some embodiments of the present disclosure;
FIG. 35 is a plan view of a semiconductor device according to some embodiments of the present disclosure;
FIGS. 36 and 37 are plan views illustrating a method for manufacturing a semiconductor device according to some embodiments of the present disclosure;
FIG. 38 is a plan view of a semiconductor device according to some embodiments of the present disclosure;
FIGS. 39 and 40 are plan views illustrating a method for manufacturing a semiconductor device according to some embodiments of the present disclosure;
FIG. 41 is a plan view of a semiconductor device according to some embodiments of the present disclosure;
FIGS. 42 and 43 are plan views illustrating a method for manufacturing a semiconductor device according to some embodiments of the present disclosure;
FIG. 44 is a plan view of a semiconductor device according to some embodiments of the present disclosure; and
FIGS. 45 and 46 are plan views illustrating a method for manufacturing a semiconductor device according to some embodiments of the present disclosure.

### DETAILED DESCRIPTION

To clarify the present disclosure, the same elements or equivalents are referred to by the same reference numerals throughout the specification. Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, thicknesses of some layers and areas are excessively displayed.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

In addition, unless explicitly described to the contrary, the word "comprises", and variations such as "comprises" or "comprising", will be understood to imply the inclusion of stated elements but not the exclusion of any other elements. As used herein, the singular forms "a," "an" and "the" are intended to include the plural forms as well, unless the context clearly indicates otherwise. The term "and/or" includes any and all combinations of one or more of the associated listed items. The term "connected" may be used herein to refer to a physical and/or electrical connection and may refer to a direct or indirect physical and/or electrical connection. The term "exposed" may be used to define a relationship between particular layers or surfaces, but it does not require the layer or surface to be free of other elements or layers thereon in the completed device. Components or layers described with reference to "overlap" in a particular direction may be at least partially obstructed by one another when viewed along a line extending in the particular direction or in a plane perpendicular to the particular direction. The terms "first," "second," etc. may be used herein to merely distinguish one component, element, etc., from another.

Hereinafter, the present disclosure will be described in detail by describing embodiments of the present disclosure with reference to the accompanying drawings.

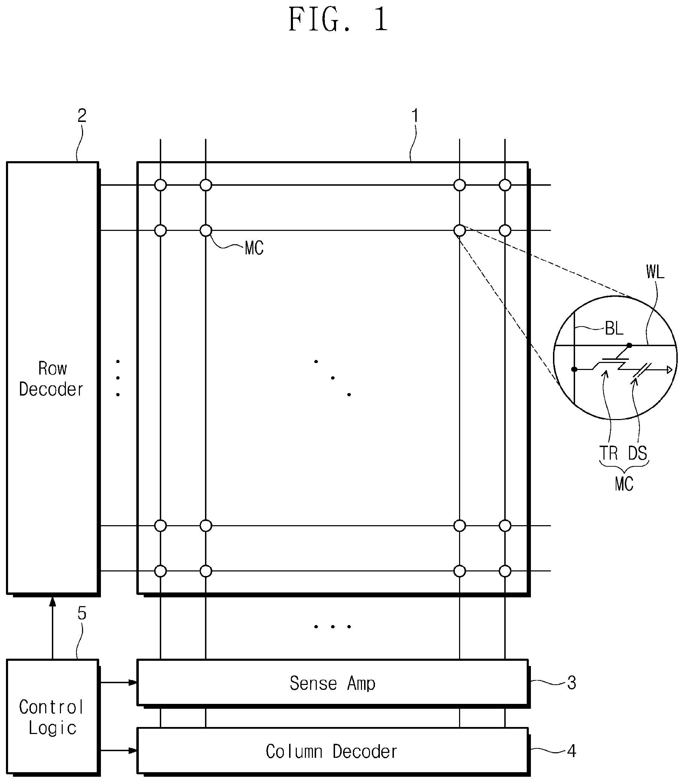

FIG. 1 is a block diagram illustrating a semiconductor device according to some embodiments of the present disclosure.

Referring to FIG. 1, the semiconductor device may include a memory cell array 1, a row decoder 2, a sense amplifier 3, a column decoder 4, and a control logic 5.

The memory cell array 1 may include a plurality of memory cells MC that are two-dimensionally or three-dimensionally arranged. Each of the memory cells MC may be connected to a word line WL and a bit line BL crossing each other. Each of the memory cells MC may include a selection element TR and a data storage element DS. The selection element TR and the data storage element DS may be electrically connected to each other. The selection element TR may be connected to the word line WL and the bit line BL, and may be provided in a point, for example at or adjacent a point, at which the word line WL and the bit line BL are crossing each other.

The selection element TR may include a field effect transistor. The data storage element DS may include a capacitor, a magnetic tunnel junction pattern, or a variable resistor. When the selection element TR includes the field effect transistor, a gate terminal of the transistor may be connected to the word line WL, and source/drain terminals of the transistor may be respectively connected to the bit line BL and the data storage element DS.

The row decoder 2 may select any one of the word lines WL of the memory cell array 1 by decoding an address input from the outside thereof. The address decoded by the row decoder 2 may be supplied to a row driver (not shown), and the row driver may supply a predetermined voltage to a selected word line WL and unselected word lines WL in response to a control signal generated by one or more control circuits.

The sense amplifier 3 may sense and amplify a voltage difference between a bit line BL and a reference bit line selected according to the address decoded by the column decoder 4, and may output the voltage difference.

The column decoder 4 may supply a data transmission path between the sense amplifier 3 and an external device (for example, a memory controller). The column decoder 4 may select any one of the bit lines BL of the memory cell array 1 by decoding an address input from the outside thereof. The control logic 5 may generate a control signal that controls an operation of writing a data to or reading a data from the memory cell array 1.

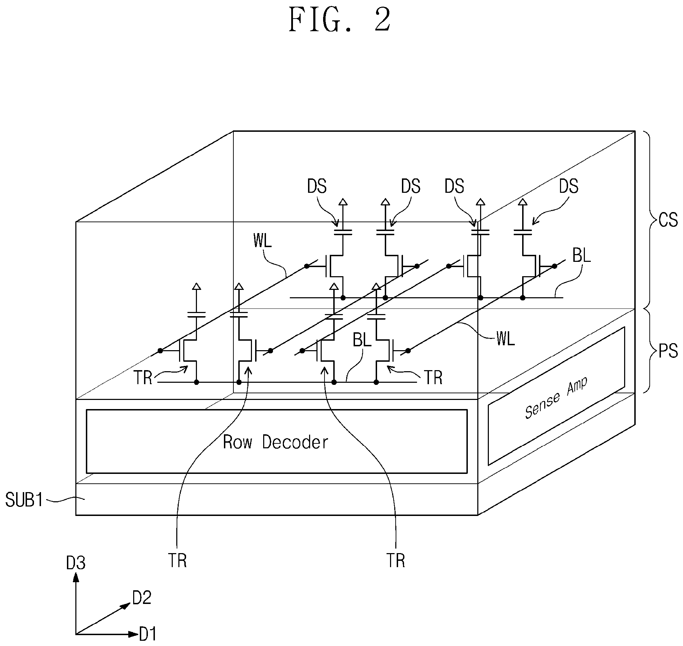

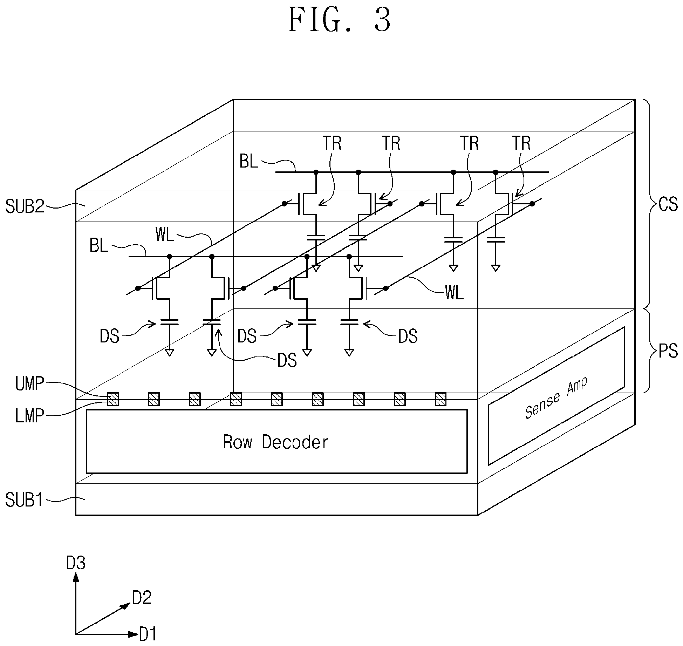

FIGS. 2 and 3 are respectively perspective views schematically illustrating a semiconductor device according to some embodiments of the present disclosure.

Referring to FIGS. 2 and 3, the semiconductor device may include a peripheral circuit structure PS on a first substrate SUB1, and a cell array structure CS on the peripheral circuit structure PS. Hereinafter, a first direction D1 and a second direction D2 are directions parallel to an upper surface of the first substrate SUB1 and crossing each other (e.g. the first direction D1 and the second direction D2 may be parallel to an upper surface of the first substrate SUB1 and may be different and/or perpendicular to one another), and a third direction D3 is a direction vertical or perpendicular to the upper surface of the first substrate SUB1. The peripheral circuit structure PS and the cell array structure CS may be stacked on the first substrate SUB1 in the third direction D3.

The peripheral circuit structure PS may include a core and peripheral circuits formed on the first substrate SUB1. The core and peripheral circuits may include the row and column decoders 2 and 4, the sense amplifier 3 and the control logic 5 described with reference to FIG. 1.

The cell array structure CS may include the memory cell array 1 (see FIG. 1) including the memory cells MC (see FIG. 1) that are two-dimensionally or three-dimensionally arranged. For example, the selection element TR (see FIG. 1) of each of the memory cells MC (see FIG. 1) may include a vertical channel transistor (VCT). The vertical channel transistor may include a channel pattern extending lengthwise along the third direction D3.

Referring to FIG. 2, according to some embodiments, the peripheral circuit structure PS may be disposed between the first substrate SUB1 and the cell array structure CS, and may be electrically connected to the cell array structure CS through conductive contacts.

Referring to FIG. 3, according to some embodiments, the semiconductor device may have a chip-to-chip bonding structure. Specifically, the peripheral circuit structure PS may be provided on the first substrate SUB1, and first metal pads LMP may be disposed on the peripheral circuit structure PS. The first metal pads LMP may be electrically connected to the core and peripheral circuits. The cell array structure CS may be provided on a second substrate SUB2. Second metal pads UMP may be provided under the cell array structure CS. The second metal pads UMP may be electrically connected to the memory cell array 1 (see FIG. 1). The first metal pads LMP in the peripheral circuit structure PS and the second metal pads UMP of the cell array structure CS may be directly bonded to each other. The peripheral circuit structure PS and the cell array structure CS may be electrically connected to each other through the first and second metal pads LMP and UMP.

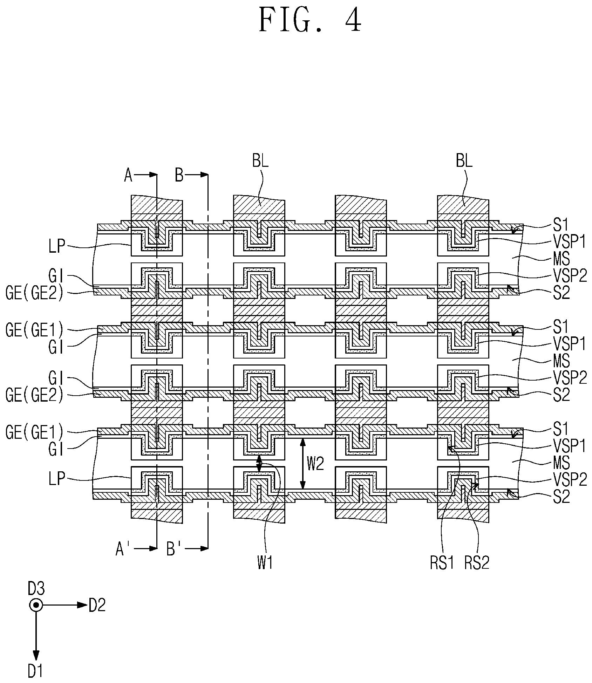

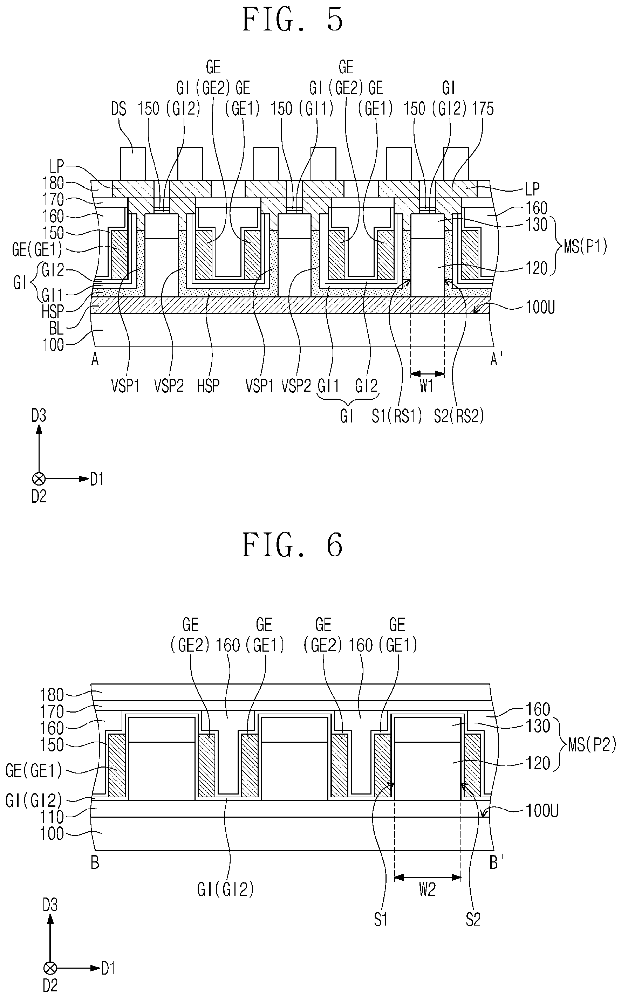

FIG. 4 is a plan view of a semiconductor device according to some embodiments of the present disclosure. FIG. 5 is a cross-sectional view taken along A-A' of FIG. 4, and FIG. 6 is a cross-sectional view taken along B-B' of FIG. 4.

Referring to FIGS. 4 to 6, the cell array structure CS described with reference to FIGS. 2 and 3 may be disposed on a substrate 100. According to some embodiments, the substrate 100 may include the first substrate SUB1 and the peripheral circuit structure PS of FIG. 2, and may further include an insulating layer covering or overlapping the peripheral circuit structure PS. The cell array structure CS may be disposed on the insulating layer. According to other embodiments, the substrate 100 may include the second substrate SUB2 of FIG. 3, and may further include an insulating layer on the second substrate SUB2. The cell array structure CS may be disposed on the insulating layer.

Hereinafter, components of the cell array structure CS will be described.

The bit lines BL may be disposed on the substrate 100. The bit lines BL may extend in the first direction D1, and may be spaced apart from each other in the second direction D2. The first direction D1 and the second direction D2 may be parallel to an upper surface 100U of the substrate 100, and may cross (for example, be perpendicular to) each other. Insulating patterns 110 may be interposed between the bit lines BL, and may extend between the bit lines BL in the first direction D1. The bit lines BL may include a conductive material. For example, the bit lines BL may include at least one of a doped semiconductor material (for example, doped silicon, doped germanium, or the like), metal (for example, Ti, Mo, W, Cu, Al, Ta, Ru, Ir, Co, and/or the like), metal silicide (for example, silicide of Ti, Mo, W, Cu, Al, Ta, Ru, Ir, Co, and/or the like), or conductive metal nitride (for example, nitride of Ti, Mo, W, Cu, Al, Ta, Ru, Ir, Co, and/or the like). According to some embodiments, the bit lines BL may include a carbon-based two-dimensional material (for example, graphene), a carbon-based three-dimensional material (for example, carbon nanotube), or a combination thereof. The insulating patterns 110 may include an insulating material, and for example, may include silicon oxide, silicon nitride, and/or silicon oxynitride.

Mold structures MS may be disposed on the bit lines BL and the insulating patterns 110, and may cross the bit lines BL and the insulating patterns 110. The mold structures MS may extend in the second direction D2, and may be spaced apart from each other in the first direction D1. Each of the mold structures MS may include a lower mold pattern 120 and an upper mold pattern 130 stacked in the third direction D3 that is vertical or perpendicular to the upper surface 100U of the substrate 100. The lower mold pattern 120 may extend in the second direction D2 to cross the bit lines BL and the insulating patterns 110. The upper mold pattern 130 may be disposed on an upper surface of the lower mold pattern 120, and may extend along the upper surface of the lower mold pattern 120 in the second direction D2. The lower mold pattern 120 may include an insulating material, and for example, may include silicon oxide, silicon nitride, and/or silicon oxynitride. The upper mold pattern 130 may include an insulating material different from the lower mold pattern 120, and for example, may include silicon nitride.

Each of the mold structures MS may include a first part P1 vertically (for example, in the third direction D3) overlapping at least a portion of each of the bit lines BL, and a second part P2 vertically (for example, in the third direction D3) overlapping at least a portion of each of the insulating patterns 110 between the bit lines BL. Each of the mold structures MS may have a width along the first direction D1, and a first width W1 of the first part P1 may be different from a second width W2 of the second part P2. According to some embodiments, the first width W1 of the first part P1 may be smaller or less than the second width W2 of the second part P2.

Each of the mold structures MS may have a first side surface S1 and a second side surface S2 opposed to each other in the first direction D1. Each of the first side surface S1 and the second side surface S2 may have an uneven structure (e.g., the first side surface S1 and the second side surface S2 have a nonlinear shape in the second direction D2 due to one or more recesses and/or protrusions, as described below in further detail. The recesses and/or protrusions of the first side surface S1 and/or the second side surface S2 may be collectively (or individually) referred to hereinafter as a "nonlinear portion"). According to some embodiments, the first side surface S1 of each of the mold structures MS may have a first recessed side surface RS1 recessed from the first part P1 toward an inside of each of the mold structures MS (e.g., the first recessed side surface RS 1 extends toward a center of the mold structure MS). Accordingly, the first part P1 of each of the mold structures MS may include a first recess region defined by the first recessed side surface RS1. The second side surface S2 of each of the mold structures MS may have a second recessed side surface RS2 recessed from the first part P1 toward the inside of each of the mold structures MS (e.g., the second recessed side surface RS2 extends toward a center of the mold structure MS). Accordingly, the first part P1 of each of the mold structures MS may include a second recess region defined by the second recessed side surface RS2. The first recessed side surface RS1 and the second recessed side surface RS2 may face away from each other in the first direction D1, and may be mirrored (or symmetrical) to each other.

A first vertical semiconductor pattern VSP1 and a second vertical semiconductor pattern VSP2 may be disposed on each of the bit lines BL, and may be spaced apart from each other in the first direction D1 with each of the mold structures MS therebetween. The first vertical semiconductor pattern VSP1 and the second vertical semiconductor pattern VSP2 may be spaced apart from each other in the first direction D1 with the first part P1 of each of the mold structures MS therebetween. The first vertical semiconductor pattern VSP1 may be disposed on the first side surface S1 of each of the mold structures MS, and may extend along the uneven structure of the first side surface S1. The second vertical semiconductor pattern VSP2 may be disposed on the second side surface S2 of each of the mold structures MS, and may extend along the uneven structure of the second side surface S2. According to some embodiments, the first vertical semiconductor pattern VSP1 may be disposed on the first recessed side surface RS1 of the first part P1, and may conformally extend along the first recessed side surface RS1. The first vertical semiconductor pattern VSP1 may partially fill the first recess region. The second vertical semiconductor pattern VSP2 may be disposed on the second recessed side surface RS2 of the first part P1, and may conformally extend along the second recessed side surface RS2. The second recess region may be partially filled with the second vertical semiconductor pattern VSP2.

A horizontal semiconductor pattern HSP may be disposed on each of the bit lines BL, and between the mold structures MS. The horizontal semiconductor pattern HSP may be disposed between a pair of mold structures MS that are next or adjacent to each other among the mold structures MS. The horizontal semiconductor pattern HSP may connect a lower portion of the first vertical semiconductor pattern VSP1 disposed on the first recessed side surface RS1 of the first part P1 of one of the pair of mold structures MS, and a lower portion of the second vertical semiconductor pattern VSP2 disposed on the second recessed side surface RS2 of the first part P1 of the other of the pair of mold structures MS. A lower surface of the horizontal semiconductor pattern HSP may be in contact with an upper surface of each of the bit lines BL. The horizontal semiconductor pattern HSP may be in contact with the lower portions of the first vertical semiconductor pattern VSP1 and the second vertical semiconductor pattern VSP2 without a boundary surface. The first vertical semiconductor pattern VSP1, the second vertical semiconductor pattern VSP2 and the horizontal semiconductor pattern HSP may be connected to each other to be integrally configured, and may be referred to as a semiconductor pattern. The semiconductor pattern VSP1, VSP2 or HSP may have a U-shape in a cross-sectional view.

According to some embodiments, the first vertical semiconductor pattern VSP1, the second vertical semiconductor pattern VSP2 and the horizontal semiconductor pattern HSP may include an oxide semiconductor. For example, the oxide semiconductor may include InₓGa_{y}Zn_{z}O, InₓGa_{y}Si_{z}O, InₓSn_{y}Zn_{z}O, InₓZn_{y}O, ZnₓO, ZnₓSn_{y}O, ZnₓO_{y}N, ZrₓZn_{y}Sn_{z}O, SnₓO, HfₓIn_{y}Zn_{z}O, GaₓZn_{y}Sn_{z}O, AlₓZn_{y}Sn_{z}O, YbₓGa_{y}Zn_{z}O, InₓGa_{y}O or a combination thereof. The first vertical semiconductor pattern VSP1, the second vertical semiconductor pattern VSP2 and the horizontal semiconductor pattern HSP may include, for example, indium-gallium-zinc oxide (IGZO). The first vertical semiconductor pattern VSP1, the second vertical semiconductor pattern VSP2 and the horizontal semiconductor pattern HSP may include a single layer or multiple layers of the oxide semiconductor, and may include the amorphous, crystalline, or polycrystalline oxide semiconductor. The first vertical semiconductor pattern VSP1, the second vertical semiconductor pattern VSP2 and the horizontal semiconductor pattern HSP may have a greater bandgap energy than silicon. For example, the first vertical semiconductor pattern VSP1, the second vertical semiconductor pattern VSP2 and the horizontal semiconductor pattern HSP may have a bandgap energy of about 1.5 eV to about 5.6 eV, and in some embodiments, may have a bandgap energy of about 2.0 eV to about 4.0 eV.

According to some embodiments, the first vertical semiconductor pattern VSP1, the second vertical semiconductor pattern VSP2 and the horizontal semiconductor pattern HSP may include a semiconductor material, and for example, may include at least one of silicon (for example, single-crystalline silicon), germanium, and/or silicon-germanium. According to some embodiments, the first vertical semiconductor pattern VSP1, the second vertical semiconductor pattern VSP2 and the horizontal semiconductor pattern HSP may include a two-dimensional semiconductor material, and for example, may include graphene, carbon nanotube, or a combination thereof.

Gate electrodes GE may be disposed on the bit lines BL and the insulating patterns 110, and may cross the bit lines BL and the insulating patterns 110. The gate electrodes GE may extend in the second direction D2, and may be spaced apart from each other in the first direction D1. The gate electrodes GE may include a first gate electrode GE1 on the first side surface S1 of each of the mold structures MS, and a second gate electrode GE2 on the second side surface S2 of each of the mold structures MS. The first gate electrode GE1 may extend along the first side surface S1 of each of the mold structures MS in the second direction D2, and the second gate electrode GE2 may extend along the second side surface S2 of each of the mold structures MS in the second direction D2. The first gate electrode GE1 and the second gate electrode GE2 may be spaced apart from each other in the first direction D1 with each of the mold structures MS therebetween.

The first vertical semiconductor pattern VSP1 may be interposed between the first gate electrode GE1 and the first side surface S1 of each of the mold structures MS. The first vertical semiconductor pattern VSP1 may be interposed between the first gate electrode GE1 and the first recessed side surface RS 1 of the first part P1 of each of the mold structures MS. According to some embodiments, the first gate electrode GE1 may conformally extend along the first recessed side surface RS1 of the first part P1 of each of the mold structures MS, and may partially fill the first recess region. The second vertical semiconductor pattern VSP2 may be interposed between the second gate electrode GE2 and the second side surface S2 of each of the mold structures MS. The second vertical semiconductor pattern VSP2 may be interposed between the second gate electrode GE2 and the second recessed side surface RS2 of the first part P1 of each of the mold structures MS. According to some embodiments, the second gate electrode GE2 may conformally extend along the second recessed side surface RS2 of the first part P1 of each of the mold structures MS, and may partially fill the second recess region.

A pair of gate electrodes GE among the gate electrodes GE may be disposed between the pair of mold structures MS that are next to or adjacent to each other among the mold structures MS. The pair of gate electrodes GE may include the first gate electrode GE1 disposed on the first side surface S1 of one of the mold structures MS, and the second gate electrode GE2 disposed on the second side surface S2 of the other of the mold structures MS. The pair of gate electrodes GE may be disposed on the horizontal semiconductor pattern HSP, and may cross the horizontal semiconductor pattern HSP.

The gate electrodes GE may include a conductive material, and for example, may include at least one of metal (for example, Ti, Mo, W, Cu, Al, Ta, Ru, Ir, Co, or the like), metal silicide (for example, silicide of Ti, Mo, W, Cu, Al, Ta, Ru, Ir, Co, or the like), and/or conductive metal nitride (for example, nitride of Ti, Mo, W, Cu, Al, Ta, Ru, Ir, Co, or the like).

A gate insulating pattern GI may be interposed between each of the mold structures MS and each of the gate electrodes GE. The gate insulating pattern GI may be interposed between the first gate electrode GE1 and the first side surface S1 of each of the mold structures MS, and may extend between the first vertical semiconductor pattern VSP1 and the first gate electrode GE1. The gate insulating pattern GI may be interposed between the second gate electrode GE2 and the second side surface S2 of each of the mold structures MS, and may extend between the second vertical semiconductor pattern VSP2 and the second gate electrode GE2. The gate insulating pattern GI may extend between the horizontal semiconductor pattern HSP and each of the gate electrodes GE.

The gate insulating pattern GI may be interposed between the first gate electrode GE1 and the first vertical semiconductor pattern VSP1 disposed on the first side surface S1 (for example, the first recessed side surface RS 1) of one of the pair of mold structures MS, and may extend between the horizontal semiconductor pattern HSP and the first gate electrode GE1. In addition, the gate insulating pattern GI may be interposed between the second gate electrode GE2 and the second vertical semiconductor pattern VSP2 disposed on the second side surface S2 (for example, the second recessed side surface RS2) of the other of the pair of mold structures MS, and may extend between the horizontal semiconductor pattern HSP and the second gate electrode GE2. The gate insulating pattern GI may extend between each of the insulating patterns 110 and each of the gate electrodes GE.

The gate insulating pattern GI may include a first gate insulating pattern GI1 and a second gate insulating pattern GI2. The first gate insulating pattern GI1 may be interposed between the first gate electrode GE1 and the first vertical semiconductor pattern VSP1, and may extend between the horizontal semiconductor pattern HSP and the first gate electrode GE1. In addition, the first gate insulating pattern GI1 may be interposed between the second gate electrode GE2 and the second vertical semiconductor pattern VSP2, and may extend between the horizontal semiconductor pattern HSP and the second gate electrode GE2. The second gate insulating pattern GI2 may be interposed between the first gate insulating pattern GI1 and the first gate electrode GE1, and between the first gate insulating pattern GI1 and the second gate electrode GE2, and may extend between the first gate electrode GE1 and the first side surface S1 of each of the mold structures MS, and between the second gate electrode GE2 and the second side surface S2 of each of the mold structures MS. The second gate insulating pattern GI2 may extend between each of the insulating patterns 110 and each of the gate electrodes GE, and may further extend onto an upper surface of each of the mold structures MS.

For example, the gate insulating pattern GI may include at least one of silicon oxide or a high dielectric material. In the present disclosure, the high dielectric material may be defined as a material having a higher dielectric constant than silicon oxide.

A buried insulating layer 160 may be interposed between the mold structures MS, and may cover or at least partially overlap upper surfaces and side surfaces of the gate electrodes GE. The buried insulating layer 160 may be disposed between the first gate electrode GE1 on the first side surface S1 of one of the pair of mold structures MS, and the second gate electrode GE2 on the second side surface S2 of the other of the pair of mold structures MS, and may extend onto upper surfaces of the first gate electrode GE1 and the second gate electrode GE2. The gate insulating pattern GI may be interposed between the first gate electrode GE1 and the first vertical semiconductor pattern VSP1 on the first side surface S1 (for example, the first recessed side surface RS1) of one of the pair of mold structures MS, and may extend between the buried insulating layer 160 and the first side surface S1 (for example, the first recessed side surface RS1) of the one of the pair of mold structures MS along the third direction D3. The gate insulating pattern GI may be interposed between the second gate electrode GE2 and the second vertical semiconductor pattern VSP2 on the second side surface S2 (for example, the second recessed side surface RS2) of the other of the pair of mold structures MS, and may extend between the buried insulating layer 160 and the second side surface S2 (for example, the second recessed side surface RS2) of the other of the pair of mold structures MS along the third direction D3. The gate insulating pattern GI may extend between the horizontal semiconductor pattern HSP and the buried insulating layer 160.

The gate insulating pattern GI may extend between each of the insulating patterns 110 and the buried insulating layer 160. The gate insulating pattern GI may extend between the first gate electrode GE1 and the first side surface S1 of one of the pair of mold structures MS, and between the buried insulating layer 160 and the first side surface S1 of the one of the pair of mold structures MS, and may extend between the second gate electrode GE2 and the second side surface S2 of the other of the pair of mold structures MS, and between the buried insulating layer 160 and the second side surface S2 of the other of the pair of mold structures MS.

A capping insulating layer 150 may be interposed between each of the gate electrodes GE and the buried insulating layer 160. The capping insulating layer 150 may be interposed between the buried insulating layer 160 and an upper surface of each of the gate electrodes GE, and may extend between the buried insulating layer 160 and a side surface of each of the gate electrodes GE. The capping insulating layer 150 may extend onto the horizontal semiconductor pattern HSP between the first gate electrode GE1 on the first side surface S1 of one of the pair of mold structures MS, and the second gate electrode GE2 on the second side surface S2 of the other of the pair of mold structures MS, and may be interposed between the buried insulating layer 160 and the gate insulating pattern GI on the horizontal semiconductor pattern HSP. The capping insulating layer 150 may extend onto each of the insulating patterns 110 between the first gate electrode GE1 on the first side surface S1 of one of the pair of mold structures MS, and the second gate electrode GE2 on the second side surface S2 of the other of the pair of mold structures MS, and may be interposed between the buried insulating layer 160 and the gate insulating pattern GI on each of the insulating patterns 110. The capping insulating layer 150 may extend between the buried insulating layer 160 and the gate insulating pattern GI on the first side surface S1 of each of the mold structures MS, and between the buried insulating layer 160 and the gate insulating pattern GI on the second side surface S2 of each of the mold structures MS. The capping insulating layer 150 may extend onto an upper surface of each of the mold structures MS, and the gate insulating pattern GI may be interposed between the capping insulating layer 150 and an upper surface of each of the mold structures MS.

For example, the buried insulating layer 160 may include a silicon oxide layer, a silicon nitride layer, a silicon oxynitride layer and/or a low dielectric layer. The capping insulating layer 150 may include an insulating material different from the buried insulating layer 160, and for example, may include a silicon nitride layer.

A first upper insulating layer 170 may be disposed on the mold structures MS and the buried insulating layer 160. The first upper insulating layer 170 may cover or at least partially overlap the capping insulating layer 150 on upper surfaces of the mold structures MS, and may cover or at least partially overlap an upper surface of the buried insulating layer 160. A second upper insulating layer 180 may be disposed on the first upper insulating layer 170, and may cover or at least partially overlap an upper surface of the first upper insulating layer 170. For example, the first and second upper insulating layers 170 and 180 may include a silicon oxide layer, a silicon nitride layer, a silicon oxynitride layer and/or a low dielectric layer.

Node contacts 175 may be respectively disposed on the first and second vertical semiconductor patterns VSP1 and VSP2. Each of the node contacts 175 may penetrate or extend into the first upper insulating layer 170, the capping insulating layer 150 and the gate insulating pattern GI, and may be electrically connected to a corresponding one of the first and second vertical semiconductor patterns VSP1 and VSP2. Each of the node contacts 175 may be in contact with an upper surface of the corresponding one of the first and second vertical semiconductor patterns VSP1 and VSP2.

Landing pads LP may be respectively disposed on the node contacts 175. Each of the landing pads LP may penetrate the second upper insulating layer 180, and may be electrically connected to each of the node contacts 175. Each of the landing pads LP may be in contact with an upper surface of each of the node contacts 175, and in a plan view, may have various shapes such as a circle, an ellipse, a rectangle, a square, a rhombus, or a hexagon.

The node contacts 175 and the landing pads LP may include the same conductive material as each other. For example, the node contacts 175 and landing pads LP may be composed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or a combination thereof, but embodiments of the present disclosure are not limited thereto.

Data storage patterns DS may be respectively disposed on the landing pads LP. The data storage patterns DS may be respectively electrically connected to the first and second vertical semiconductor patterns VSP1 and VSP2 through the landing pads LP and the node contacts 175. The data storage patterns DS may be disposed so as to be spaced apart from each other along the first direction D1 and the second direction D2. According to some embodiments, the data storage patterns DS may be capacitors. In this case, the data storage patterns DS may include lower electrodes respectively disposed on the landing pads LP, an upper electrode covering or at least partially overlapping the lower electrodes, and a dielectric film between each of the lower electrodes and the upper electrode. According to other embodiments, the data storage patterns DS may be variable resistance patterns capable of being switched between two resistance states by an electrical pulse. For example, the data storage patterns DS may include a phase-change material changing a crystalline state depending on an amount of current, a perovskite compound, a transition metal oxide, a magnetic material, a ferromagnetic material, or an antiferromagnetic material.

According to the present disclosure, the first vertical semiconductor pattern VSP1 may be used as a vertical channel of a transistor including the first gate electrode GE1 and the first vertical semiconductor pattern VSP1, and the second vertical semiconductor pattern VSP2 may be used as a vertical channel of a transistor including the second gate electrode GE2 and the second vertical semiconductor pattern VSP2. The first and second vertical semiconductor patterns VSP1 and VSP2 may be respectively disposed on the first and second recessed side surfaces RS1 and RS2 of the first part P1 of each of the mold structures MS, and may conformally extend along the first and second recessed side surfaces RS1 and RS2. Accordingly, in a plan view, an area of each of the first and second vertical semiconductor patterns VSP1 and VSP2 may increase. As a result, channel widths of the vertical channel transistors using the first and second vertical semiconductor patterns VSP1 and VSP2 as channels may increase, and thus operation characteristics of the vertical channel transistors may be improved.

In addition, since the area of each of the first and second vertical semiconductor patterns VSP1 and VSP2 increases, a contact area between each of the first and second vertical semiconductor patterns VSP1 and VSP2 and each of the node contacts 175 may increase. Accordingly, resistance between each of the first and second vertical semiconductor patterns VSP1 and VSP2 and each of the node contacts 175 may be reduced, and thus electrical characteristics of the vertical channel transistors may be improved.

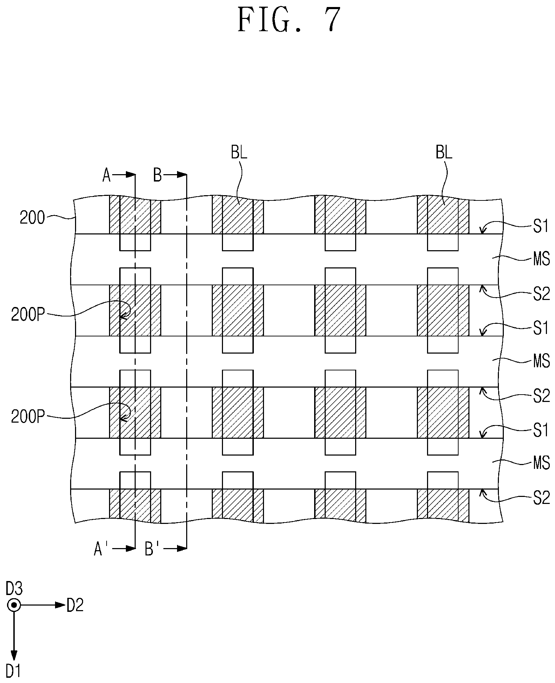

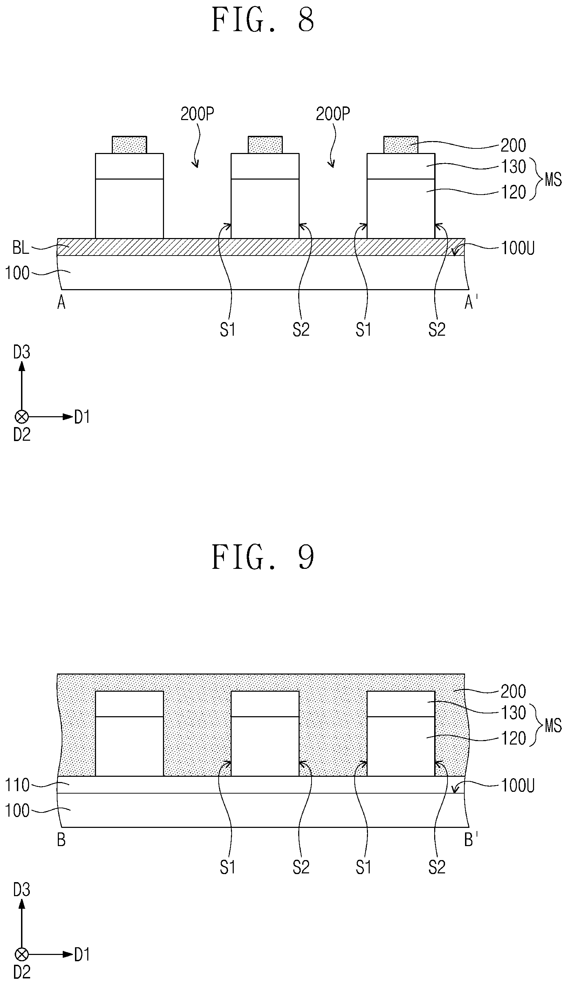

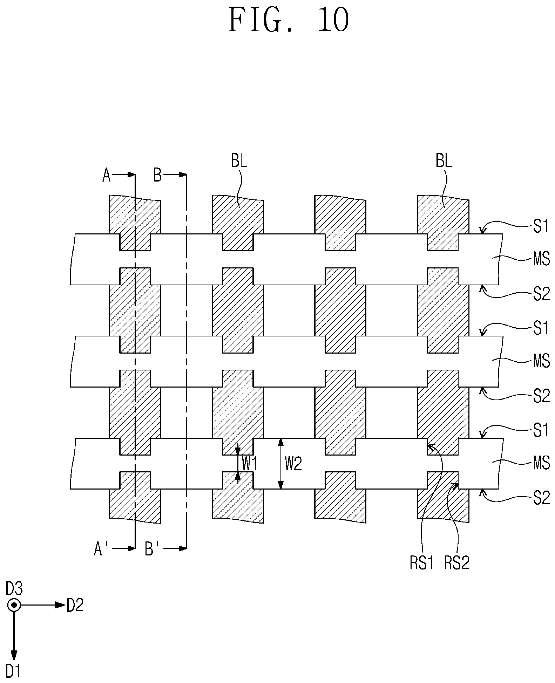

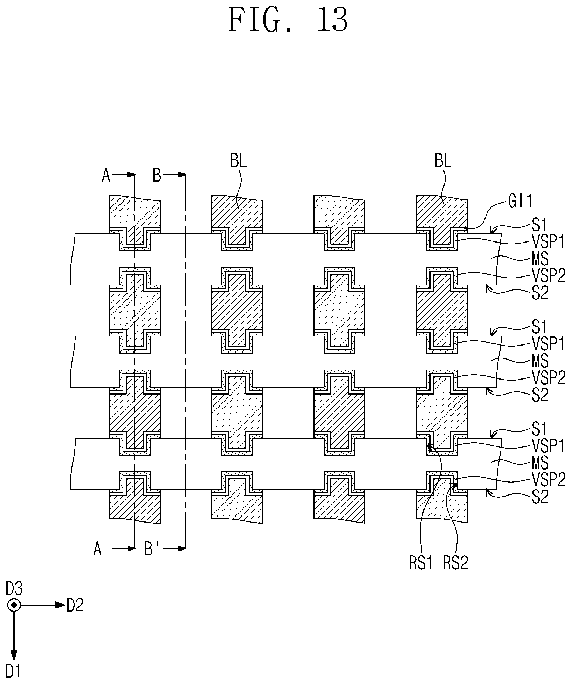

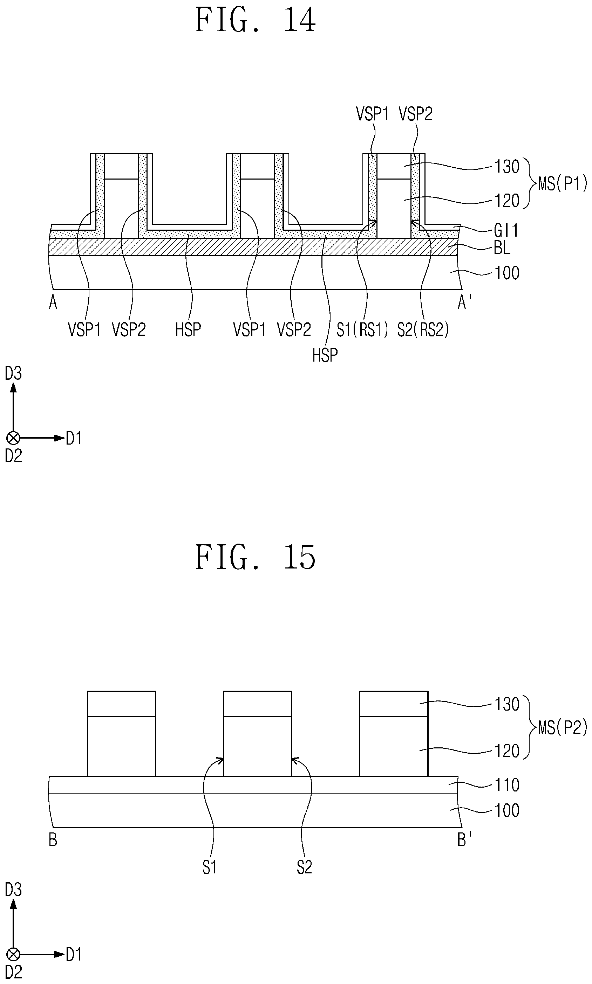

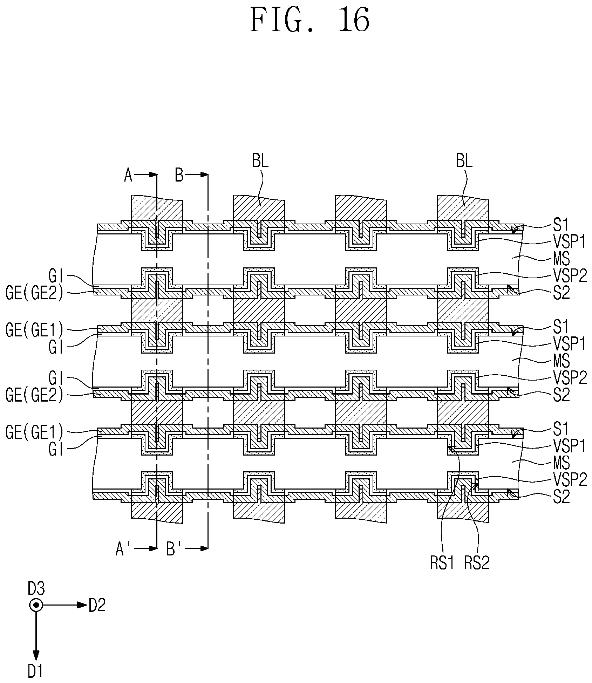

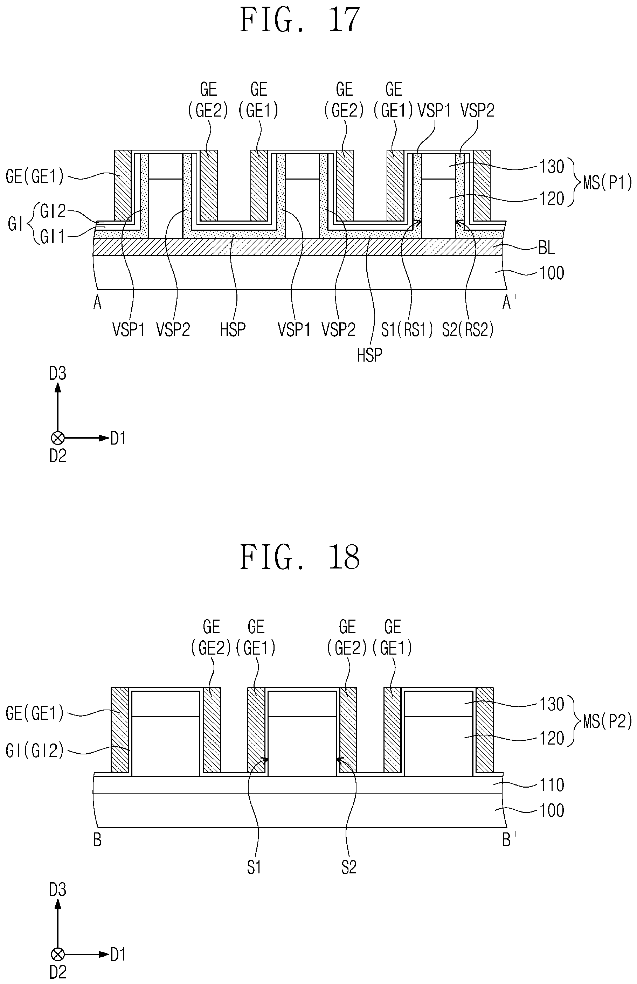

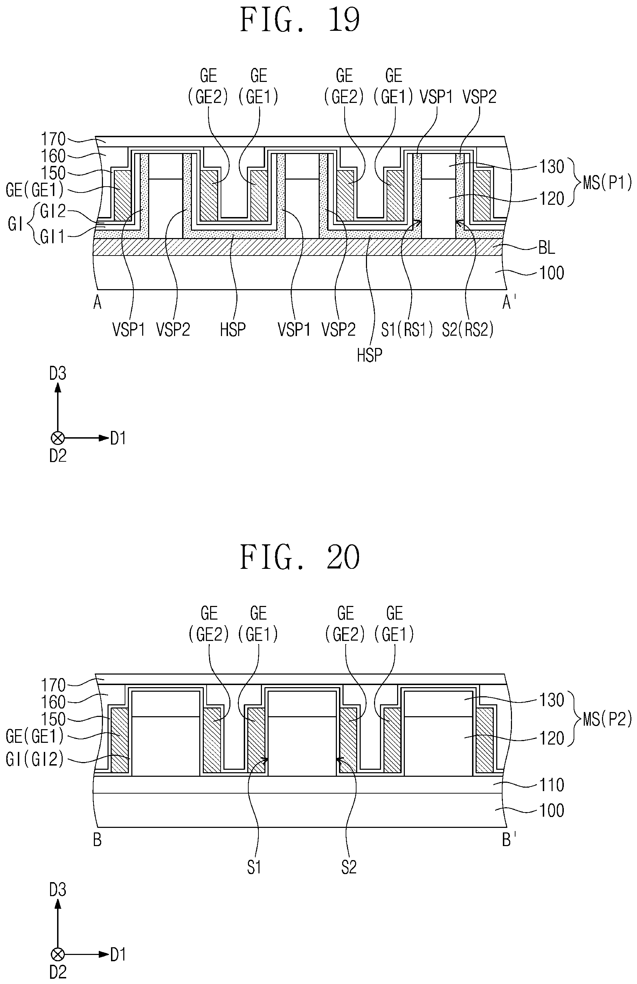

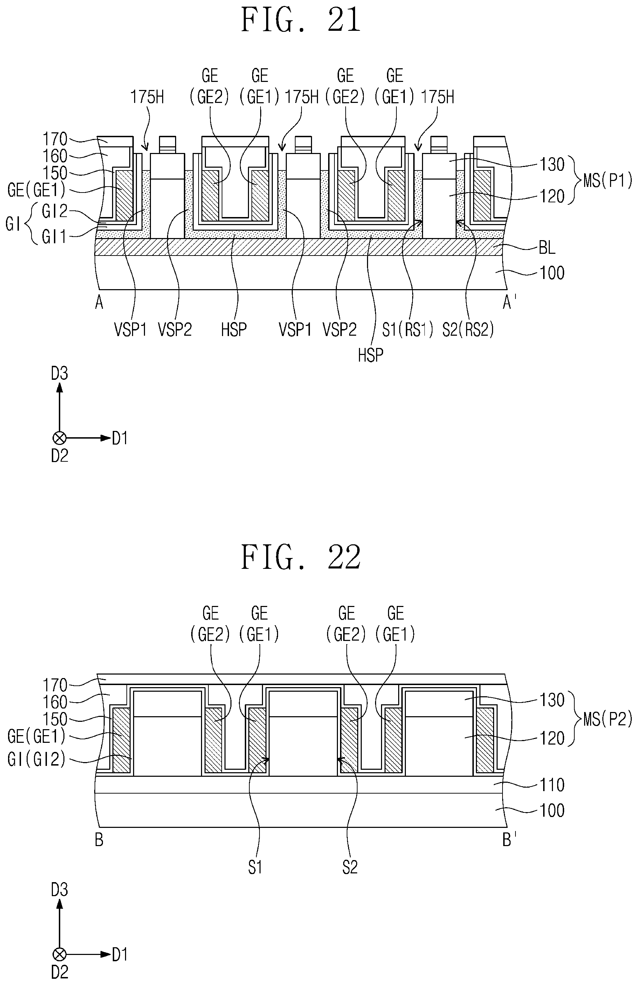

FIGS. 7, 10, 13 and 16 are plan views illustrating a method for manufacturing a semiconductor device according to some embodiments of the present disclosure. FIGS. 8, 9, 11, 12, 14, 15, 17, 18, 19, 20, 21 and 22 are cross-sectional views illustrating a method for manufacturing a semiconductor device according to some embodiments of the present disclosure. FIGS. 8 and 9 are cross-sectional views respectively taken along A-A' and B-B' of FIG. 7, FIGS. 11 and 12 are cross-sectional views respectively taken along A-A' and B-B' of FIG. 10, FIGS. 14 and 15 are cross-sectional views respectively taken along A-A' and B-B' of FIG. 13, and FIGS. 17 and 18 are cross-sectional views respectively taken along A-A' and B-B' of FIG. 16. FIGS. 19 and 21 are cross-sectional views taken along A-A' of FIG. 4, and FIGS. 20 and 22 are cross-sectional views taken along B-B' of FIG. 4. In order to simplify description, duplicate description of the semiconductor device described with reference to FIGS. 4 to 6 will be omitted.

Referring to FIGS. 7 to 9, the bit lines BL may be formed on the substrate 100. For example, forming the bit lines BL may include forming a conductive film on the substrate and patterning the conductive film. The bit lines BL may extend in the first direction D1, and may be spaced apart from each other in the second direction D2. The insulating patterns 110 may be formed between the bit lines BL, and may extend between the bit lines BL in the first direction D1. For example, forming the insulating patterns 110 may include forming an insulating layer covering or at least partially overlapping the bit lines BL and at least partially filling a space between the bit lines BL, and planarizing the insulating layer until upper surfaces of the bit lines BL are exposed.

The mold structures MS may be formed on the bit lines BL and the insulating patterns 110, and may cross the bit lines BL and the insulating patterns 110. The mold structures MS may extend in the second direction D2, and may be spaced apart from each other in the first direction D1. Each of the mold structures MS may include the lower mold pattern 120 and the upper mold pattern 130 stacked in the third direction D3. For example, forming the mold structures MS may include successively stacking a lower mold film and an upper mold film on the bit lines BL and insulating patterns 110, and successively patterning the upper mold film and the lower mold film. Each of the mold structures MS may have the first side surface S1 and the second side surface S2 opposed to each other in the first direction D1.

A mask film 200 may be formed on the bit lines BL and the insulating patterns 110, and may cover or at least partially overlap the mold structures MS. The mask film 200 may have a plurality of openings 200P spaced apart from each other in the first direction D1 and the second direction D2. According to some embodiments, each of the plurality of openings 200P may have a shape of a bar extending in the first direction D1, and may expose portions of a pair of mold structures MS that are next or adjacent to each other among the mold structures MS, and an upper surface of a bit line BL between the pair of mold structures MS. That is, each of the plurality of openings 200P may expose the first side surface S1 of one of the pair of mold structures MS and the second side surface S2 of the other of the pair of the mold structures MS, and the upper surface of the bit line BL between the pair of mold structures MS. For example, the mask film 200 may be a photoresist film or hard-mask film.

Referring to FIGS. 10 to 12, an etching process using the mask film 200 as an etching mask may be performed, and the portions of the mold structures MS exposed by the plurality of openings 200P may be etched by the etching process. Each of the mold structures MS may include the first part P1 having the first width W1, and the second part P2 having the second width W2 greater than the first width W1 by the etching process. The first part P1 of each of the mold structures MS may vertically (for example, in the third direction D3) overlap at least a portion of each of the bit lines BL, and the second part P2 of each of the mold structures MS may vertically (for example, in the third direction D3) overlap at least a portion of each of the insulating patterns 110 between the bit lines BL.

Each of the first side surface S1 and the second side surface S2 of each of the mold structures MS may have an uneven structure by the etching process. According to some embodiments, the first side surface S1 of each of the mold structures MS may have a first recessed side surface RS1 recessed from the first part P1 toward an inside of each of the mold structures MS (e.g., the first recessed side surface RS1 extends toward a center of the mold structure MS). Accordingly, the first part P1 of each of the mold structures MS may include a first recess region defined by the first recessed side surface RS1. The second side surface S2 of each of the mold structures MS may have a second recessed side surface RS2 recessed from the first part P1 toward the inside of each of the mold structures MS (e.g., the second recessed side surface RS2 extends toward a center of the mold structure MS). Accordingly, the first part P1 of each of the mold structures MS may include a second recess region defined by the second recessed side surface RS2. The first recessed side surface RS1 and the second recessed side surface RS2 may face away from each other in the first direction D1, and may be mirrored (or symmetrical) to each other.

The mask film 200 may be removed after the etching process. For example, the mask film 200 may be removed by ashing and/or a strip process.

Referring to FIGS. 13 to 15, the first vertical semiconductor pattern VSP1 may be formed on the first recessed side surface RS 1 of the first part P1 of each of the mold structures MS, and the second vertical semiconductor pattern VSP2 may be formed on the second recessed side surface RS2 of the first part P1 of each of the mold structures MS. The first vertical semiconductor pattern VSP1 may conformally extend along the first recessed side surface RS1, and may partially fill the first recess region. The second vertical semiconductor pattern VSP2 may conformally extend along the second recessed side surface RS2, and may partially fill the second recess region.

The horizontal semiconductor pattern HSP may be formed on each of the bit lines BL and between the mold structures MS. The horizontal semiconductor pattern HSP may be formed between a pair of mold structures MS that are next or adjacent to each other among the mold structures MS. The horizontal semiconductor pattern HSP may connect a lower portion of the first vertical semiconductor pattern VSP1 disposed on the first recessed side surface RS1 of the first part P1 of one of the pair of mold structures MS, and a lower portion of the second vertical semiconductor pattern VSP2 disposed on the second recessed side surface RS2 of the first part P1 of the other of the pair of mold structures MS. The first vertical semiconductor pattern VSP1, the second vertical semiconductor pattern VSP2 and the horizontal semiconductor pattern HSP may be connected to each other to be integrally configured, and may be referred to as a semiconductor pattern. The semiconductor pattern VSP1, VSP2 or HSP may have a U-shape in a cross-sectional view. Although the horizontal semiconductor pattern HSP may be formed between a pair of mold structures MS that are next or adjacent to each other among the mold structures MS, it should be understood that the horizontal semiconductor pattern HSP is not shown in FIG. 13 in the interests of clarity.

The first gate insulating pattern GI1 may be formed so as to cover or at least partially overlap the first vertical semiconductor pattern VSP1, the second vertical semiconductor pattern VSP2 and the horizontal semiconductor pattern HSP. The first gate insulating pattern GI1 may be formed on the first recessed side surface RS 1 of the first part P1 of each of the mold structures MS, and may cover or at least partially overlap the first vertical semiconductor pattern VSP1. The first gate insulating pattern GI1 may be formed on the second recessed side surface RS2 of the first part P1 of each of the mold structures MS, and may cover or at least partially overlap the second vertical semiconductor pattern VSP2. The first gate insulating pattern GI1 may be formed on each of the bit lines BL, and between the mold structures MS, and may cover or at least partially overlap the horizontal semiconductor pattern HSP. The first gate insulating pattern GI1 may have a U-shape in a cross-sectional view. Although the first gate insulating pattern GI1 may be formed on each of the bit lines BL, and between the mold structures MS, and may cover or at least partially overlap the horizontal semiconductor pattern HSP, it should be understood that the portion of the first gate insulating pattern GI1 which may cover or at least partially overlap the horizontal semiconductor pattern HSP on each of the bit lines BL between the mold structures MS is not shown in FIG. 13 in the interests of clarity.

For example, forming the first vertical semiconductor pattern VSP1, the second vertical semiconductor pattern VSP2, the horizontal semiconductor pattern HSP and the first gate insulating pattern GI1 may include forming a semiconductor film covering or at least partially overlapping the mold structures MS, and covering or at least partially overlapping the bit lines BL and the insulating patterns 110 between the mold structures MS, forming a first gate insulating layer on the semiconductor film, removing the semiconductor film and the first gate insulating layer on the insulating patterns 110, and planarizing the semiconductor film and the first gate insulating layer on the bit lines BL until upper surfaces of the mold structures MS are exposed.

Each of the semiconductor film and the first gate insulating layer may conformally cover or overlap the first side surface S1, the first recessed side surface RS1, the second side surface S2, the second recessed side surface RS2 and an upper surface of each of the mold structures MS, and may conformally cover or overlap upper surfaces of the insulating patterns 110 and the bit lines BL between the mold structures MS. For example, removing the semiconductor film and the first gate insulating layer on the insulating patterns 110 may include removing the semiconductor film and the first gate insulating layer from the first side surface S1, and from the second side surface S2 and the upper surface of each of the mold structures MS on the insulating patterns 110, and removing the semiconductor film and the first gate insulating layer from upper surfaces of the insulating patterns 110 between the mold structures MS. Planarizing the semiconductor film and the first gate insulating layer on the bit lines BL may include removing the semiconductor film and the first gate insulating layer from the upper surface of each of the mold structures MS on the bit lines BL. Accordingly, the first vertical semiconductor pattern VSP1 may be formed on the first side surface S1 of each of the mold structures MS on the bit lines BL, and the second vertical semiconductor pattern VSP2 may be formed on the second side surface S2 of each of the mold structures MS on the bit lines BL. In addition, the horizontal semiconductor pattern HSP may be formed on an upper surface of each of the bit lines BL between the mold structures MS, and the first gate insulating pattern GI1 may be formed so as to conformally cover or overlap the first vertical semiconductor pattern VSP1, the second vertical semiconductor pattern VSP2 and the horizontal semiconductor pattern HSP.

Referring to FIGS. 16 to 18, the second gate insulating pattern GI2 may be formed so as to cover or at least partially overlap the mold structures MS, and so as to cover or at least partially overlap the bit lines BL and the insulating patterns 110 between the mold structures MS. The second gate insulating pattern GI2 may conformally cover or overlap the first side surface S1, the first recessed side surface RS1, the second side surface S2, the second recessed side surface RS2 and an upper surface of each of the mold structures MS, and may conformally cover or overlap upper surfaces of the insulating patterns 110 and the bit lines BL between the mold structures MS. The second gate insulating pattern GI2 may cover or at least partially overlap the first side surface S1 of each of the mold structures MS, and may cover or at least partially overlap the first gate insulating pattern GI1 and the first vertical semiconductor pattern VSP1 on the first recessed side surface RS1. The second gate insulating pattern GI2 may cover or at least partially overlap the second side surface S2 of each of the mold structures MS, and may cover or at least partially overlap the first gate insulating pattern GI1 and the second vertical semiconductor pattern VSP2 on the second recessed side surface RS2. The second gate insulating pattern GI2 may cover or at least partially overlap the first gate insulating pattern GI1 and the horizontal semiconductor pattern HSP on the bit lines BL between the mold structures MS, and may extend onto upper surfaces of the mold structures MS. The first gate insulating pattern GI1 and the second gate insulating pattern GI2 may be referred to as the gate insulating pattern GI. Although the second gate insulating pattern GI2 may cover or at least partially overlap the first gate insulating pattern GI1 and the horizontal semiconductor pattern HSP on the bit lines BL between the mold structures MS, it should be understood that the portion of the second gate insulating pattern GI2 which may cover or at least partially overlap the first gate insulating pattern GI1 and the horizontal semiconductor pattern HSP on the bit lines BL between the mold structures MS is not shown in FIG. 16 in the interests of clarity.

The gate electrodes GE may be formed on the bit lines BL and the insulating patterns 110, and may cross the bit lines BL and the insulating patterns 110. The gate electrodes GE may extend in the second direction D2, and may be spaced apart from each other in the first direction D1. The gate electrodes GE may include a first gate electrode GE1 on the first side surface S1 of each of the mold structures MS, and a second gate electrode GE2 on the second side surface S2 of each of the mold structures MS. The first gate electrode GE1 and the second gate electrode GE2 may be spaced apart from each other in the first direction D1 with each of the mold structures MS therebetween. For example, forming the gate electrodes GE may include forming a gate electrode film covering or at least partially overlapping the mold structures MS on the bit lines BL and the insulating patterns 110, and anisotropically etching the gate electrode film. The anisotropic etching process may be performed such that the gate electrodes GE are partially left on side surfaces of the mold structures MS.

Referring to FIGS. 4, 19 and 20, upper portions of the gate electrodes GE may be recessed. Thereafter, the capping insulating layer 150 may be formed so as to cover or at least partially overlap the mold structures MS and the gate electrodes GE. The capping insulating layer 150 may cover or at least partially overlap the gate insulating pattern GI on the upper surfaces of the mold structures MS, and may extend so as to cover or at least partially overlap the gate insulating pattern GI on upper side surfaces of the mold structures MS. The capping insulating layer 150 may extend so as to cover or at least partially overlap upper surfaces and side surfaces of the gate electrodes GE, and may extend so as to cover or at least partially overlap the gate insulating pattern GI between the mold structures MS, and between the gate electrodes GE.

The buried insulating layer 160 may be formed on the capping insulating layer 150, and may at least partially fill a space between the mold structures MS. The buried insulating layer 160 may extend between the gate electrodes GE. For example, forming the buried insulating layer 160 may include forming an insulating layer covering or at least partially overlapping the mold structures MS and the gate electrodes GE, and planarizing the insulating layer until the capping insulating layer 150 on the upper surfaces of the mold structures MS are exposed.

The first upper insulating layer 170 may be formed on the mold structures MS and the buried insulating layer 160. The first upper insulating layer 170 may cover or at least partially overlap the capping insulating layer 150 on upper surfaces of the mold structures MS, and may cover or at least partially overlap an upper surface of the buried insulating layer 160.

Referring to FIGS. 4, 21 and 22, node contact holes 175H may be formed in the first upper insulating layer 170. Each of the node contact holes 175H may penetrate or extend into the first upper insulating layer 170, the capping insulating layer 150 and the gate insulating pattern GI, and may expose a corresponding one of the first and second vertical semiconductor patterns VSP1 and VSP2. Upper portions, exposed by the node contact holes 175H, of the first and second vertical semiconductor patterns VSP1 and VSP2 may be recessed, and thus each of the node contact holes 175H may extend between the gate insulating pattern GI and a side surface (for example, the first side surface S1 or the second side surface S2) of each of the mold structures MS.

Referring back to FIGS. 4 to 6, the node contacts 175 may be respectively formed in the node contact holes 175H, and the landing pads LP may be respectively formed on the node contacts 175. For example, forming the node contacts 175 and the landing pads LP may include forming, on the first upper insulating layer 170, an upper conductive film at least partially filling the node contact holes 175H and extending onto the first upper insulating layer 170, and patterning the upper conductive film. The landing pads LP may be formed by patterning the upper conductive film, and portions of the upper conductive film filling the node contact holes 175H may be referred to as the node contacts 175.

The second upper insulating layer 180 may be formed so as to at least partially fill a space between the landing pads LP. For example, forming the second upper insulating layer 180 may include forming the second upper insulating layer 180 covering or at least partially overlapping the landing pads LP on the first upper insulating layer 170, and planarizing the second upper insulating layer 180 until upper surfaces of the landing pads LP are exposed. The data storage patterns DS may be respectively formed on the exposed upper surfaces of the landing pads LP.

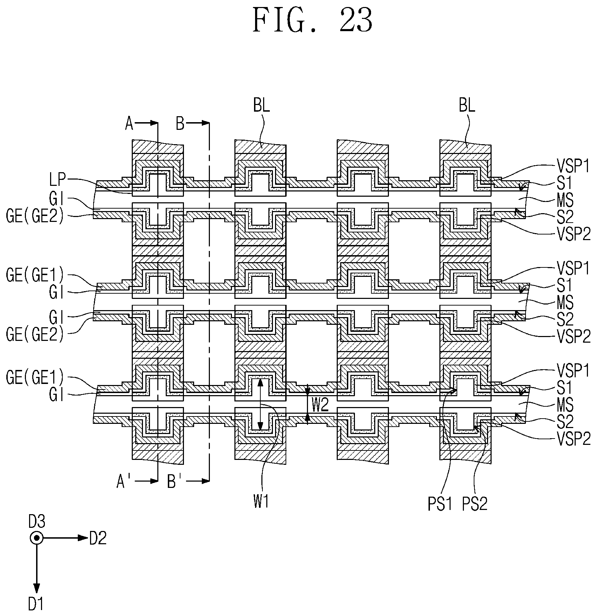

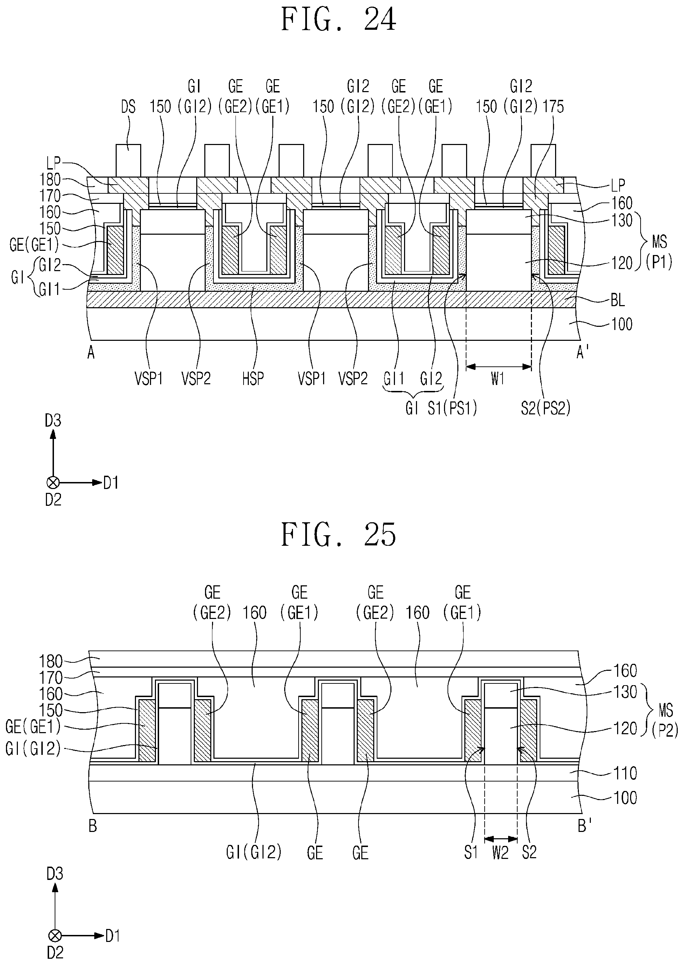

FIG. 23 is a plan view of a semiconductor device according to some embodiments of the present disclosure. FIG. 24 is a cross-sectional view taken along A-A' of FIG. 23, and FIG. 25 is a cross-sectional view taken along B-B' of FIG. 23. In order to simplify description, a difference from the semiconductor device described with reference to FIGS. 4 to 6 will be mainly described.

Referring to FIGS. 23 to 25, the mold structures MS may be disposed on the bit lines BL and the insulating patterns 110, and may cross the bit lines BL and the insulating patterns 110. The mold structures MS may extend in the second direction D2, and may be spaced apart from each other in the first direction D1.

Each of the mold structures MS may include a first part P1 vertically (for example, in the third direction D3) overlapping each of the bit lines BL, and a second part P2 vertically (for example, in the third direction D3) overlapping each of the insulating patterns 110 between the bit lines BL. The first width W1 of the first part P1 may be different from the second width W2 of the second part P2. According to some embodiments, the first width W1 of the first part P1 may be greater than the second width W2 of the second part P2.

Each of the mold structures MS may have the first side surface S1 and the second side surface S2 opposed to each other in the first direction D1. Each of the first side surface S1 and the second side surface S2 may have an uneven structure. According to some embodiments, the first side surface S1 of each of the mold structures MS may have a first protrusion side surface PS1 protruding or extending from each of the mold structures MS in the first part P1 (e.g., the first protrusion side surface PS1 extends away from a center of the mold structure MS). Accordingly, the first part P1 of each of the mold structures MS may include a first protrusion defined by the first protrusion side surface PS1. The second side surface S2 of each of the mold structures MS may have a second protrusion side surface PS2 protruding or extending from each of the mold structures MS in the first part P1 (e.g., the second protrusion side surface PS2 extends away from a center of the mold structure MS). Accordingly, the first part P1 of each of the mold structures MS may include a second protrusion defined by the second protrusion side surface PS2. The first protrusion side surface PS1 and the second protrusion side surface PS2 may face away from each other in the first direction D1, and may be mirrored (or symmetrical) to each other.

The first vertical semiconductor pattern VSP1 and the second vertical semiconductor pattern VSP2 may be disposed on each of the bit lines BL, and may be spaced apart from each other in the first direction D1 with each of the mold structures MS therebetween. The first vertical semiconductor pattern VSP1 and the second vertical semiconductor pattern VSP2 may be spaced apart from each other in the first direction D1 with the first part P1 of each of the mold structures MS therebetween. According to some embodiments, the first vertical semiconductor pattern VSP1 may be disposed on the first protrusion side surface PS1 of the first part P1, and may conformally extend along the first protrusion side surface PS1. The second vertical semiconductor pattern VSP2 may be disposed on the second protrusion side surface PS2 of the first part P1, and may conformally extend along the second protrusion side surface PS2.

The horizontal semiconductor pattern HSP may be disposed on each of the bit lines BL, and between the mold structures MS. The horizontal semiconductor pattern HSP may be disposed between a pair of mold structures MS that are next or adjacent to each other among the mold structures MS. The horizontal semiconductor pattern HSP may connect a lower portion of the first vertical semiconductor pattern VSP1 disposed on the first protrusion side surface PS1 of the first part P1 of one of the pair of mold structures MS, and a lower portion of the second vertical semiconductor pattern VSP2 disposed on the second protrusion side surface PS2 of the first part P1 of the other of the pair of mold structures MS. The first vertical semiconductor pattern VSP1, the second vertical semiconductor pattern VSP2 and the horizontal semiconductor pattern HSP may be connected to each other to be integrally configured, and may be referred to as a semiconductor pattern. The semiconductor pattern VSP1, VSP2 or HSP may have a U-shape in a cross-sectional view.

The gate electrodes GE may be disposed on the bit lines BL and the insulating patterns 110, and may cross the bit lines BL and the insulating patterns 110. The gate electrodes GE may extend in the second direction D2, and may be spaced apart from each other in the first direction D1. The gate electrodes GE may include a first gate electrode GE1 on the first side surface S1 of each of the mold structures MS, and a second gate electrode GE2 on the second side surface S2 of each of the mold structures MS.

The first vertical semiconductor pattern VSP1 may be interposed between the first gate electrode GE1 and the first side surface S1 of each of the mold structures MS. The first vertical semiconductor pattern VSP1 may be interposed between the first gate electrode GE1 and the first protrusion side surface PS1 of the first part P1 of each of the mold structures MS. According to some embodiments, the first gate electrode GE1 may conformally extend along the first protrusion side surface PS1 of the first part P1 of each of the mold structures MS. The second vertical semiconductor pattern VSP2 may be interposed between the second gate electrode GE2 and the second side surface S2 of each of the mold structures MS. The second vertical semiconductor pattern VSP2 may be interposed between the second gate electrode GE2 and the second protrusion side surface PS2 of the first part P1 of each of the mold structures MS. According to some embodiments, the second gate electrode GE2 may conformally extend along the second protrusion side surface PS2 of the first part P1 of each of the mold structures MS.

The gate insulating pattern GI may be interposed between each of the mold structures MS and each of the gate electrodes GE. The gate insulating pattern GI may be interposed between the first gate electrode GE1 and the first side surface S1 of each of the mold structures MS, and may extend between the first vertical semiconductor pattern VSP1 and the first gate electrode GE1. The gate insulating pattern GI may be interposed between the second gate electrode GE2 and the second side surface S2 of each of the mold structures MS, and may extend between the second vertical semiconductor pattern VSP2 and the second gate electrode GE2. The gate insulating pattern GI may extend between the horizontal semiconductor pattern HSP and each of the gate electrodes GE, and may extend between each of the insulating patterns 110 and each of the gate electrodes GE.

According to some embodiments, the first and second vertical semiconductor patterns VSP1 and VSP2 may be respectively disposed on the first and second protrusion side surfaces PS1 and PS2 of the first part P1 of each of the mold structures MS, and may conformally extend along the first and second protrusion side surfaces PS1 and PS2. Accordingly, in a plan view, the area of each of the first and second vertical semiconductor patterns VSP1 and VSP2 may increase. As a result, the channel widths of the vertical channel transistors using the first and second vertical semiconductor patterns VSP1 and VSP2 as channels may increase, and thus the operation characteristics of the vertical channel transistors may be improved. In addition, since the area of each of the first and second vertical semiconductor patterns VSP1 and VSP2 increases, the contact area between each of the first and second vertical semiconductor patterns VSP1 and VSP2 and each of the node contacts 175 may increase. Accordingly, the resistance between each of the first and second vertical semiconductor patterns VSP1 and VSP2 and each of the node contacts 175 may be reduced, and thus the electrical characteristics of the vertical channel transistors may be improved.

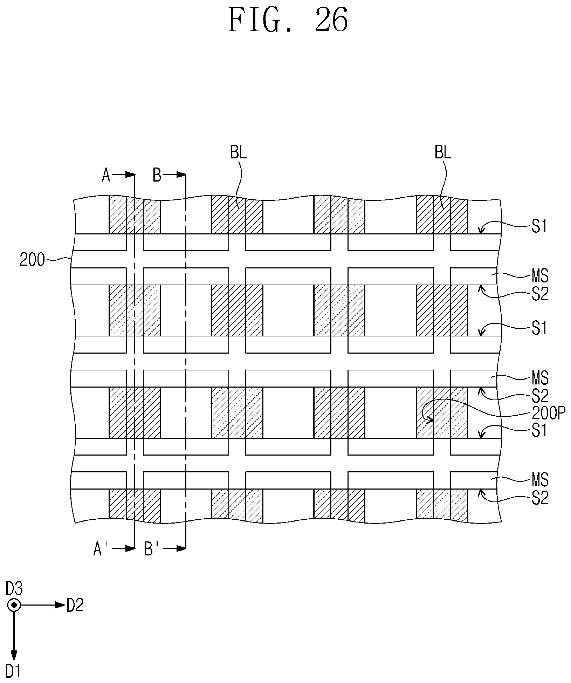

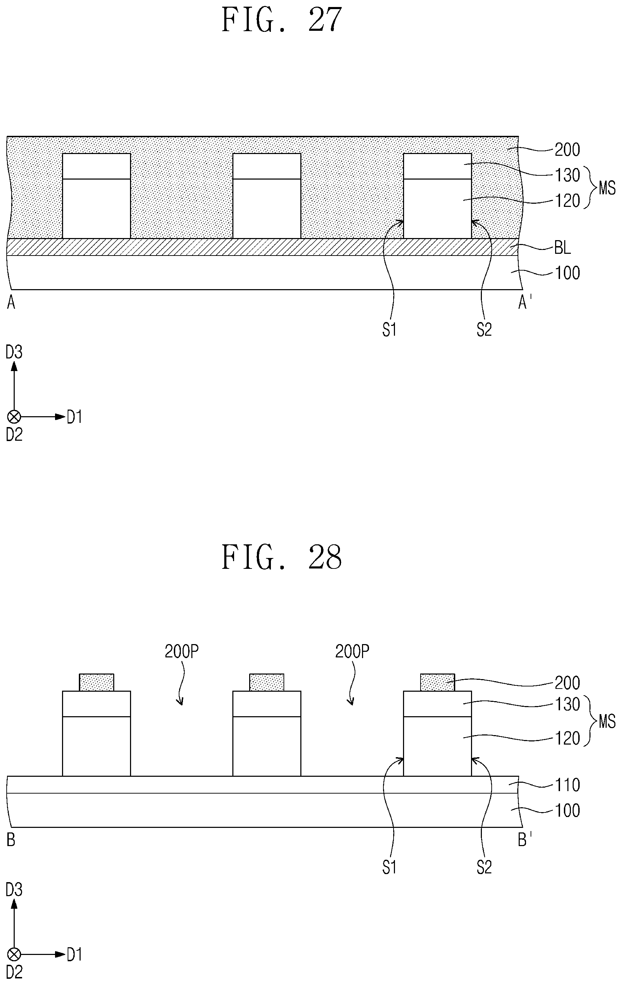

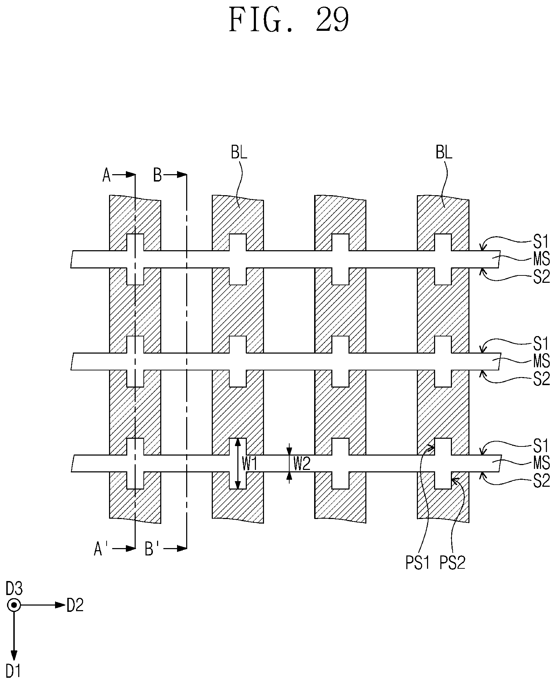

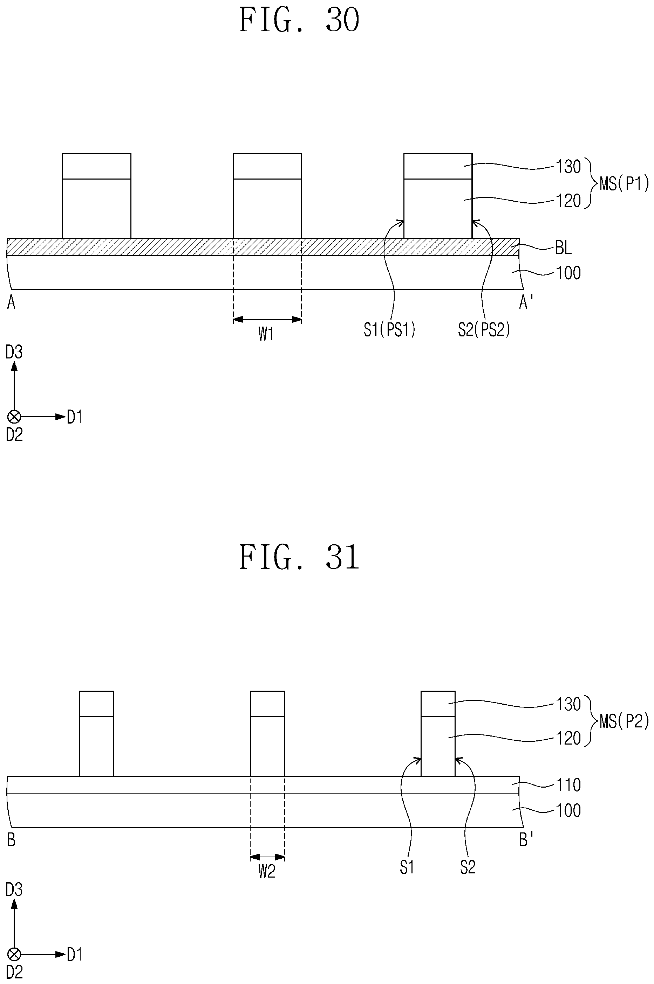

FIGS. 26 and 29 are plan views illustrating a method for manufacturing a semiconductor device according to some embodiments of the present disclosure. FIGS. 27, 28, 30 and 31 are cross-sectional views illustrating a method for manufacturing a semiconductor device according to some embodiments of the present disclosure. FIGS. 27 and 28 are cross-sectional views respectively taken along A-A' and B-B' of FIG. 26, and FIGS. 30 and 31 are cross-sectional views respectively taken along A-A' and B-B' of FIG. 29. In order to simplify description, a difference from the method for manufacturing a semiconductor device described with reference to FIGS. 7 to 22 will be mainly described.

Referring to FIGS. 26 to 28, the bit lines BL may be formed on the substrate 100, and the insulating patterns 110 may be formed between the bit lines BL. The mold structures MS may be formed on the bit lines BL and the insulating patterns 110, and may cross the bit lines BL and the insulating patterns 110. Each of the mold structures MS may have the first side surface S1 and the second side surface S2 opposed to each other in the first direction D1.

A mask film 200 may be formed on the bit lines BL and the insulating patterns 110, and may cover or at least partially overlap the mold structures MS. The mask film 200 may have a plurality of openings 200P spaced apart from each other in the first direction D1 and the second direction D2. According to some embodiments, each of the plurality of openings 200P may expose portions of a pair of mold structures MS that are next or adjacent to each other among the mold structures MS, and an upper surface of an insulating pattern 110 between the pair of mold structures MS. That is, each of the plurality of openings 200P may expose the first side surface S1 of one of the pair of mold structures MS and the second side surface S2 of the other of the pair of mold structures MS, and the upper surface of the insulating pattern 110 between the pair of mold structures MS.

Referring to FIGS. 29 to 31, an etching process using the mask film 200 as an etching mask may be performed, and the portions of the mold structures MS exposed by the plurality of openings 200P may be etched by the etching process. Each of the mold structures MS may include the first part P1 having the first width W1, and the second part P2 having the second width W2 smaller or less than the first width W1 by the etching process. The first part P1 of each of the mold structures MS may vertically (for example, in the third direction D3) overlap at least a portion of each of the bit lines BL, and the second part P2 of each of the mold structures MS may vertically (for example, in the third direction D3) overlap at least a portion of each of the insulating patterns 110 between the bit lines BL.

Each of the first side surface S1 and the second side surface S2 of each of the mold structures MS may have an uneven structure by the etching process. According to some embodiments, the first side surface S1 of each of the mold structures MS may have a first protrusion side surface PS1 protruding or extending from each of the mold structures MS in the first part P1 (e.g., the first protrusion side surface PS1 extends away from a center of the mold structure MS). Accordingly, the first part P1 of each of the mold structures MS may include a first protrusion defined by the first protrusion side surface PS1. The second side surface S2 of each of the mold structures MS may have a second protrusion side surface PS2 protruding or extending from each of the mold structures MS in the first part P1 (e.g., the second protrusion side surface PS2 extends away from a center of the mold structure MS). Accordingly, the first part P1 of each of the mold structures MS may include a second protrusion defined by the second protrusion side surface PS2. The first protrusion side surface PS1 and the second protrusion side surface PS2 may face away from each other in the first direction D1, and may be mirrored (or symmetrical) to each other.

The mask film 200 may be removed after the etching process. Thereafter, processes may be substantially performed in the same manner as the processes of the method for manufacturing a semiconductor device described with reference to FIGS. 4 to 6 and 13 to 22.

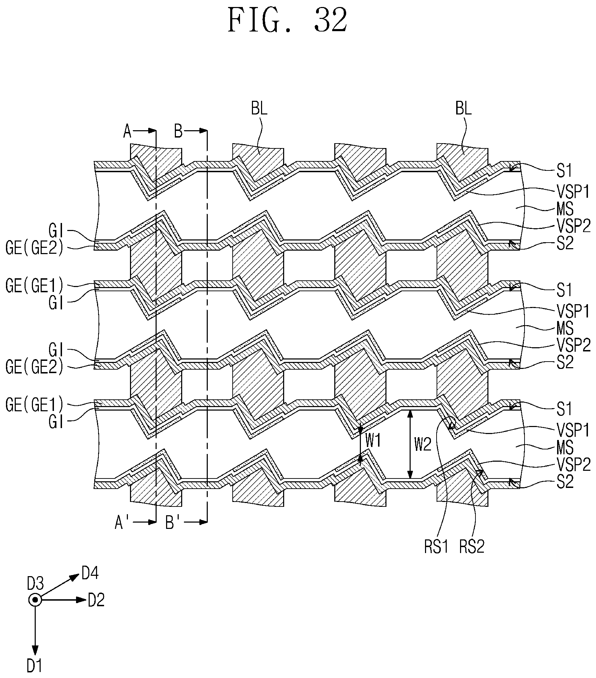

FIG. 32 is a plan view of a semiconductor device according to some embodiments of the present disclosure. The cross-sectional views taken along A-A' and B-B' of FIG. 32 are substantially respectively the same as FIGS. 5 and 6. In order to simplify description, the landing pad LP illustrated in FIGS. 4 and 23 is omitted. In order to simplify description, a difference from the semiconductor device described with reference to FIGS. 4 to 6 will be mainly described.

Referring to FIGS. 5, 6, and 32, the mold structures MS may be disposed on the bit lines BL and the insulating patterns 110, and may cross the bit lines BL and the insulating patterns 110. The mold structures MS may extend in the second direction D2, and may be spaced apart from each other in the first direction D1.

Each of the mold structures MS may include a first part P1 vertically (for example, in the third direction D3) overlapping at least a portion of each of the bit lines BL, and a second part P2 vertically (for example, in the third direction D3) overlapping at least a portion of each of the insulating patterns 110 between the bit lines BL. The first width W1 of the first part P1 may be different from the second width W2 of the second part P2. According to some embodiments, the first width W1 of the first part P1 may be smaller or less than the second width W2 of the second part P2.

Each of the mold structures MS may have the first side surface S1 and the second side surface S2 opposed to each other in the first direction D1. Each of the first side surface S1 and the second side surface S2 may have an uneven structure. According to some embodiments, the first side surface S1 of each of the mold structures MS may have a first recessed side surface RS1 recessed from the first part P1 toward an inside of each of the mold structures MS (e.g., the first recessed side surface RS 1 extends toward a center of the mold structure MS). Accordingly, the first part P1 of each of the mold structures MS may include a first recess region defined by the first recessed side surface RS1. The second side surface S2 of each of the mold structures MS may have a second recessed side surface RS2 recessed from the first part P1 toward the inside of each of the mold structures MS (e.g., the second recessed side surface RS2 extends toward a center of the mold structure MS). Accordingly, the first part P1 of each of the mold structures MS may include a second recess region defined by the second recessed side surface RS2. According to some embodiments, a width along the second direction D2 of the first recess region may be reduced in a direction getting closer to or approaching a center of each of the mold structures MS, and the first recess region may have a tapered shape toward a center of each of the mold structures MS. In addition, a width along the second direction D2 of the second recess region may be reduced in a direction getting closer to or approaching a center of each of the mold structures MS, and the second recess region may have a tapered shape toward a center of each of the mold structures MS. The first recessed side surface RS 1 and the second recessed side surface RS2 may face away from each other in the first direction D1, and may be asymmetrical.

Except for the difference described above, the semiconductor device according to the embodiments illustrated in FIG. 32 are substantially the same as the semiconductor device described with reference to FIGS. 4 to 6.

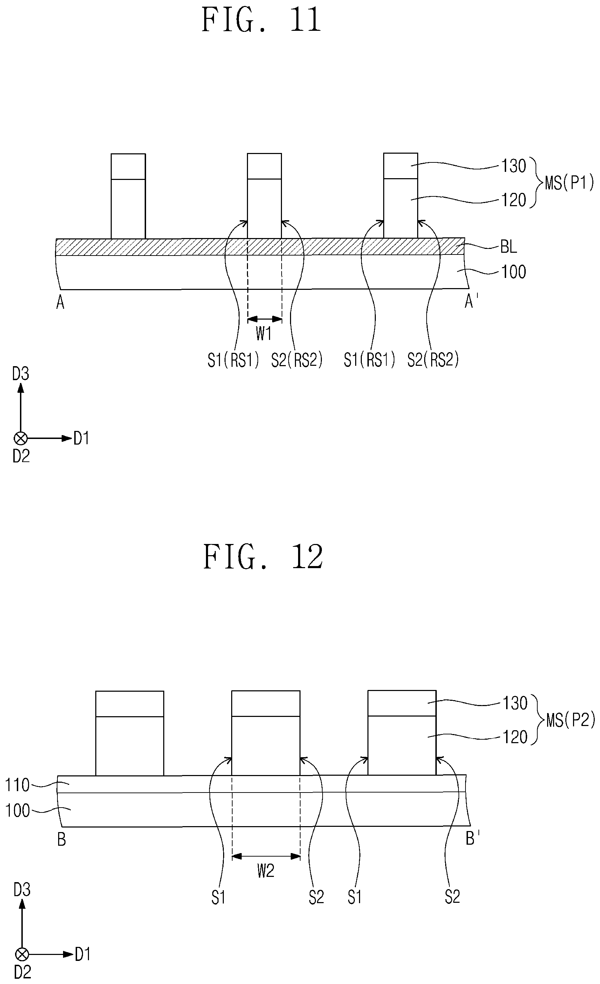

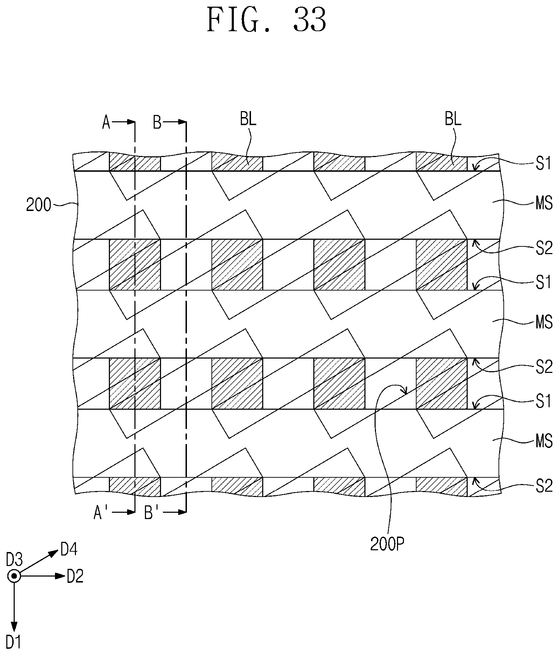

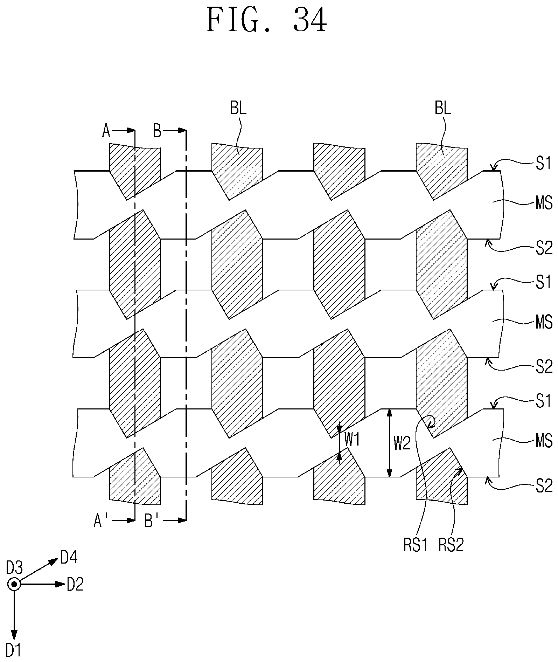

FIGS. 33 and 34 are plan views illustrating a method for manufacturing a semiconductor device according to some embodiments of the present disclosure. The cross-sectional views taken along A-A' and B-B' of FIG. 33 are substantially respectively the same as FIGS. 8 and 9 except for a shape of the opening 200P, and the cross-sectional views taken along A-A' and B-B' of FIG. 34 are substantially respectively the same as FIGS. 11 and 12. In order to simplify description, a difference from the method for manufacturing a semiconductor device described with reference to FIGS. 7 to 22 will be mainly described.

Referring to FIGS. 8, 9, and 33, the bit lines BL may be formed on the substrate 100, and the insulating patterns 110 may be formed between the bit lines BL. The mold structures MS may be formed on the bit lines BL and the insulating patterns 110, and may cross the bit lines BL and the insulating patterns 110. Each of the mold structures MS may have the first side surface S1 and the second side surface S2 opposed to each other in the first direction D1.

A mask film 200 may be formed on the bit lines BL and the insulating patterns 110, and may cover or at least partially overlap the mold structures MS. The mask film 200 may have a plurality of openings 200P spaced apart from each other in the first direction D1 and the second direction D2. According to some embodiments, each of the plurality of openings 200P may have a shape of a bar parallel to the upper surface 100U of the substrate 100, and extending in a fourth direction D4 parallel to an upper surface 100U of the substrate 100 and crossing the first and second directions D1 and D2, for example wherein the fourth direction D4 is different to the first and second directions D1 and D2. Each of the plurality of openings 200P may expose the portions of the pair of mold structures MS that are next or adjacent to each other among the mold structures MS, and an upper surface of an insulating pattern 110 between the pair of mold structures MS. That is, each of the plurality of openings 200P may expose the first side surface S1 of one of the pair of mold structures MS and the second side surface S2 of the other of the pair of mold structures MS, and the upper surface of the insulating pattern 110 between the pair of mold structures MS.

Referring to FIGS. 11, 12, and 34, an etching process using the mask film 200 as an etching mask may be performed, and the portions of the mold structures MS exposed by the plurality of openings 200P may be etched by the etching process. Each of the mold structures MS may include the first part P1 having the first width W1, and the second part P2 having the second width W2 greater than the first width W1 by the etching process. The first part P1 of each of the mold structures MS may vertically (for example, in the third direction D3) overlap at least a portion of each of the bit lines BL, and the second part P2 of each of the mold structures MS may vertically (for example, in the third direction D3) overlap at least a portion of each of the insulating patterns 110 between the bit lines BL.

Each of the first side surface S1 and the second side surface S2 of each of the mold structures MS may have an uneven structure by the etching process. According to some embodiments, the first side surface S1 of each of the mold structures MS may have a first recessed side surface RS1 recessed from the first part P1 toward an inside of each of the mold structures MS (e.g., the first recessed side surface RS1 extends toward a center of the mold structure MS). Accordingly, the first part P1 of each of the mold structures MS may include a first recess region defined by the first recessed side surface RS1. The second side surface S2 of each of the mold structures MS may have a second recessed side surface RS2 recessed from the first part P1 toward the inside of each of the mold structures MS (e.g., the second recessed side surface RS2 extends toward a center of the mold structure MS). Accordingly, the first part P1 of each of the mold structures MS may include a second recess region defined by the second recessed side surface RS2. According to some embodiments, a width along the second direction D2 of the first recess region may be reduced in a direction getting closer to or approaching a center of each of the mold structures MS, and the first recess region may have a tapered shape toward a center of each of the mold structures MS. In addition, a width along the second direction D2 of the second recess region may be reduced in a direction getting closer to or approaching a center of each of the mold structures MS, the second recess region may have a tapered shape toward a center of each of the mold structures MS. The first recessed side surface RS1 and the second recessed side surface RS2 may face away from each other in the first direction D1, and may be asymmetrical.

The mask film 200 may be removed after the etching process. Thereafter, processes may be substantially performed in the same manner as the processes of the method for manufacturing a semiconductor device described with reference to FIGS. 4 to 6 and 13 to 22.

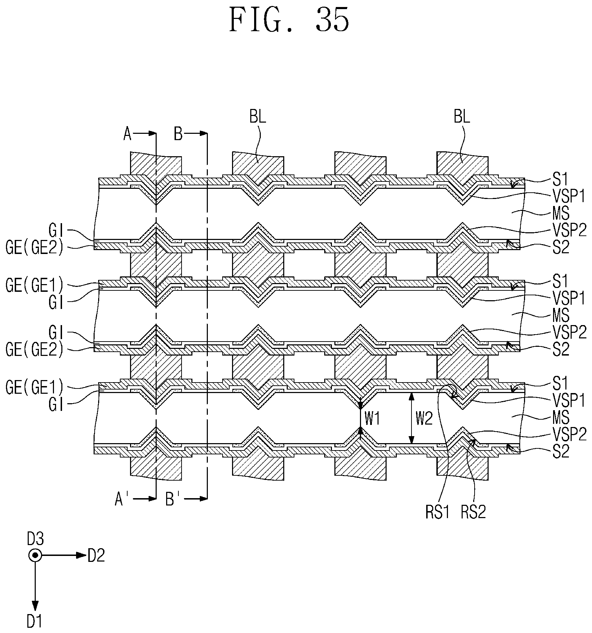

FIG. 35 is a plan view of a semiconductor device according to some embodiments of the present disclosure. The cross-sectional views taken along A-A' and B-B' of FIG. 35 are substantially respectively the same as FIGS. 5 and 6. In order to simplify description, the landing pad LP illustrated in FIGS. 4 and 23 is omitted. In order to simplify description, a difference from the semiconductor device described with reference to FIGS. 4 to 6 will be mainly described.

Referring to FIGS. 5, 6, and 35, the mold structures MS may be disposed on the bit lines BL and the insulating patterns 110, and may cross the bit lines BL and the insulating patterns 110. The mold structures MS may extend in the second direction D2, and may be spaced apart from each other in the first direction D1.

Each of the mold structures MS may include a first part P1 vertically (for example, in the third direction D3) overlapping at least a portion of each of the bit lines BL, and a second part P2 vertically (for example, in the third direction D3) overlapping at least a portion of each of the insulating patterns 110 between the bit lines BL. The first width W1 of the first part P1 may be different from the second width W2 of the second part P2. According to some embodiments, the first width W1 of the first part P1 may be smaller or less than the second width W2 of the second part P2.

Each of the mold structures MS may have the first side surface S1 and the second side surface S2 opposed to each other in the first direction D1. Each of the first side surface S1 and the second side surface S2 may have an uneven structure. According to some embodiments, the first side surface S1 of each of the mold structures MS may have a first recessed side surface RS1 recessed from the first part P1 toward an inside of each of the mold structures MS (e.g., the first recessed side surface RS 1 extends toward a center of the mold structure MS). Accordingly, the first part P1 of each of the mold structures MS may include a first recess region defined by the first recessed side surface RS1. The second side surface S2 of each of the mold structures MS may have a second recessed side surface RS2 recessed from the first part P1 toward the inside of each of the mold structures MS (e.g., the second recessed side surface RS2 extends toward a center of the mold structure MS). Accordingly, the first part P1 of each of the mold structures MS may include a second recess region defined by the second recessed side surface RS2. According to some embodiments, a width along the second direction D2 of the first recess region may be reduced in a direction getting closer to or approaching a center of each of the mold structures MS, the first recess region may have a tapered shape toward a center of each of the mold structures MS. In addition, a width along the second direction D2 of the second recess region may be reduced in a direction getting closer to or approaching a center of each of the mold structures MS, the second recess region may have a tapered shape toward a center of each of the mold structures MS. The first recessed side surface RS1 and the second recessed side surface RS2 may face away from each other in the first direction D1, and may be mirrored (or symmetrical) to each other.

Except for the difference described above, the semiconductor device according to the embodiments illustrated in FIG. 35 is substantially the same as the semiconductor device described with reference to FIGS. 4 to 6.

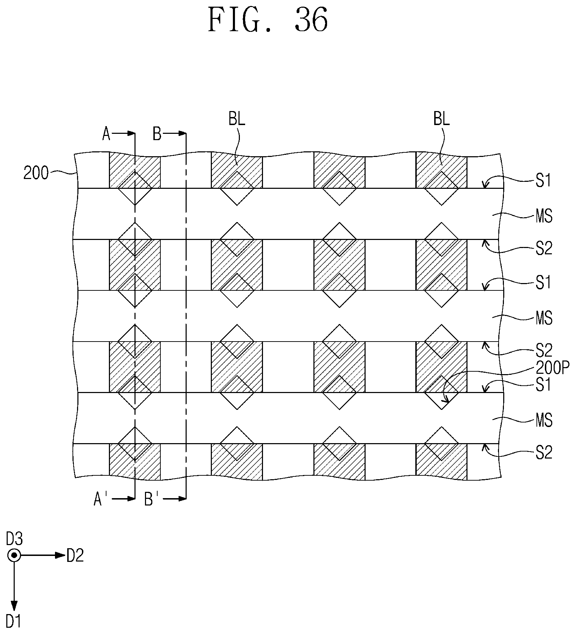

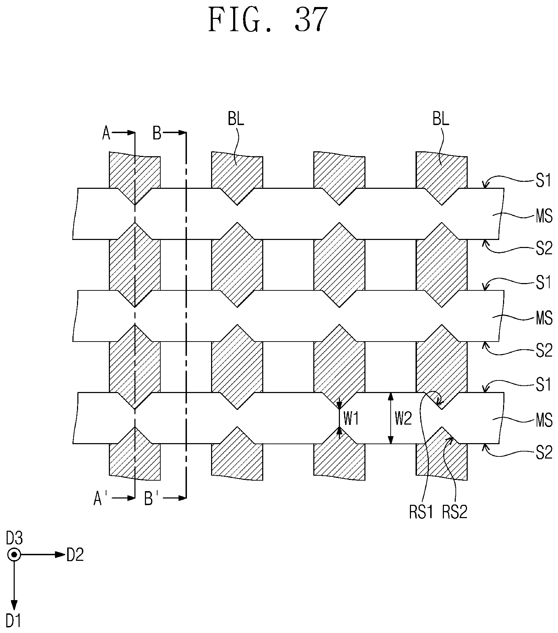

FIGS. 36 and 37 are plan views illustrating a method for manufacturing a semiconductor device according to some embodiments of the present disclosure. The cross-sectional views taken along A-A' and B-B' of FIG. 36 are substantially respectively the same as FIGS. 8 and 9, and the cross-sectional views taken along A-A' and B-B' of FIG. 37 are substantially respectively the same as FIGS. 11 and 12. In order to simplify description, a difference from the method for manufacturing a semiconductor device described with reference to FIGS. 7 to 22 will be mainly described.

Referring to FIGS. 8, 9, and 36, the bit lines BL may be formed on the substrate 100, and the insulating patterns 110 may be formed between the bit lines BL. The mold structures MS may be formed on the bit lines BL and the insulating patterns 110, and may cross the bit lines BL and the insulating patterns 110. Each of the mold structures MS may have the first side surface S1 and the second side surface S2 opposed to each other in the first direction D1.

A mask film 200 may be formed on the bit lines BL and the insulating patterns 110, and may cover or at least partially overlap the mold structures MS. The mask film 200 may have a plurality of openings 200P spaced apart from each other in the first direction D1 and the second direction D2. According to some embodiments, each of the plurality of openings 200P may have a rhombic shape, and may partially expose the mold structure MS, corresponding thereto, among the mold structures MS. Each of the plurality of openings 200P may expose the first side surface S1 or the second side surface S2 of the corresponding mold structure MS. A pair of openings 200P that are next or adjacent to each other in the first direction D1 among the plurality of openings 200P may respectively expose the first side surface S1 and the second side surface S2 of each of the mold structures MS. Openings 200P, in first columns, among the plurality of openings 200P may be spaced apart from each other in the second direction D2 along the first side surface S1 of each of the mold structures MS, and may expose the first side surface S1 of each of the mold structures MS. Openings 200P, in second columns, among the plurality of openings 200P may be spaced apart from each other in the second direction D2 along the second side surface S2 of each of the mold structures MS, and may expose the second side surface S2 of each of the mold structures MS.

Referring to FIGS. 11, 12, and 37, an etching process using the mask film 200 as an etching mask may be performed, and the portions of the mold structures MS exposed by the plurality of openings 200P may be etched by the etching process. Each of the mold structures MS may include the first part P1 having the first width W1, and the second part P2 having the second width W2 greater than the first width W1 by the etching process. The first part P1 of each of the mold structures MS may vertically (for example, in the third direction D3) overlap at least a portion of each of the bit lines BL, and the second part P2 of each of the mold structures MS may vertically (for example, in the third direction D3) overlap at least a portion of each of the insulating patterns 110 between the bit lines BL.

Each of the first side surface S1 and the second side surface S2 of each of the mold structures MS may have an uneven structure by the etching process. According to some embodiments, the first side surface S1 of each of the mold structures MS may have a first recessed side surface RS1 recessed from the first part P1 toward an inside of each of the mold structures MS (e.g., the first recessed side surface RS1 extends toward a center of the mold structure MS). Accordingly, the first part P1 of each of the mold structures MS may include a first recess region defined by the first recessed side surface RS1. The second side surface S2 of each of the mold structures MS may have a second recessed side surface RS2 recessed from the first part P1 toward the inside of each of the mold structures MS (e.g., the second recessed side surface RS2 extends toward a center of the mold structure MS). Accordingly, the first part P1 of each of the mold structures MS may include a second recess region defined by the second recessed side surface RS2. According to some embodiments, a width along the second direction D2 of the first recess region may be reduced in a direction getting closer to or approaching a center of each of the mold structures MS, and the first recess region may have a tapered shape toward a center of each of the mold structures MS. In addition, a width along the second direction D2 of the second recess region may be reduced in a direction getting closer to or approaching a center of each of the mold structures MS, and the second recess region may have a tapered shape toward a center of each of the mold structures MS. The first recessed side surface RS1 and the second recessed side surface RS2 may face away from each other in the first direction D1, and may be mirrored (or symmetrical) to each other.

The mask film 200 may be removed after the etching process. Thereafter, processes may be substantially performed in the same manner as the processes of the method for manufacturing a semiconductor device described with reference to FIGS. 4 to 6 and 13 to 22.

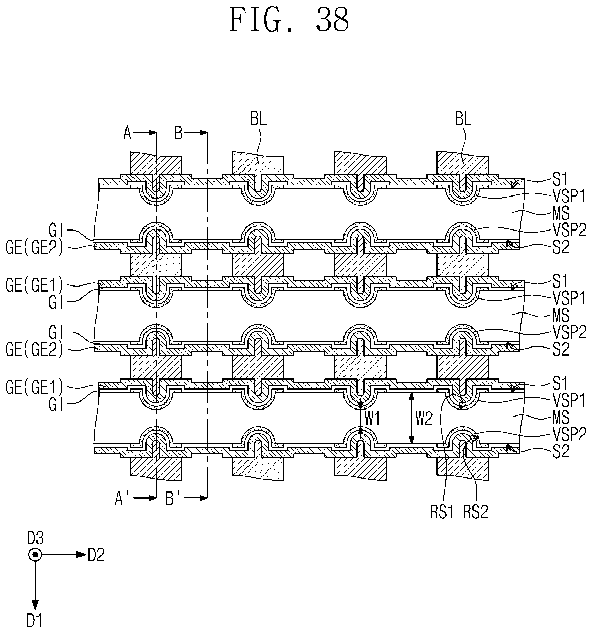

FIG. 38 is a plan view of a semiconductor device according to some embodiments of the present disclosure. The cross-sectional views taken along A-A' and B-B' of FIG. 38 are substantially respectively the same as FIGS. 5 and 6. In order to simplify description, the landing pad LP illustrated in FIGS. 4 and 23 is omitted. In order to simplify description, a difference from the semiconductor device described with reference to FIGS. 4 to 6 will be mainly described.

Referring to FIGS. 5, 6, and 38, the mold structures MS may be disposed on the bit lines BL and the insulating patterns 110, and may cross the bit lines BL and the insulating patterns 110. The mold structures MS may extend in the second direction D2, and may be spaced apart from each other in the first direction D1.

Each of the mold structures MS may include a first part P1 vertically (for example, in the third direction D3) overlapping at least a portion of each of the bit lines BL, and a second part P2 vertically (for example, in the third direction D3) overlapping at least a portion of each of the insulating patterns 110 between the bit lines BL. The first width W1 of the first part P1 may be different from the second width W2 of the second part P2. According to some embodiments, the first width W1 of the first part P1 may be smaller or less than the second width W2 of the second part P2.

Each of the mold structures MS may have the first side surface S1 and the second side surface S2 opposed to each other in the first direction D1. Each of the first side surface S1 and the second side surface S2 may have an uneven structure. According to some embodiments, the first side surface S1 of each of the mold structures MS may have a first recessed side surface RS1 recessed from the first part P1 toward an inside of each of the mold structures MS (e.g., the first recessed side surface RS 1 extends toward a center of the mold structure MS). Accordingly, the first part P1 of each of the mold structures MS may include a first recess region defined by the first recessed side surface RS1. The second side surface S2 of each of the mold structures MS may have a second recessed side surface RS2 recessed from the first part P1 toward the inside of each of the mold structures MS (e.g., the second recessed side surface RS2 extends toward a center of the mold structure MS). Accordingly, the first part P1 of each of the mold structures MS may include a second recess region defined by the second recessed side surface RS2. According to some embodiments, each of the first recessed side surface RS1 and the second recessed side surface RS2 may be a rounded side surface extending toward an inside of each of the mold structures MS. The first recessed side surface RS 1 and the second recessed side surface RS2 may face away from each other in the first direction D1, and may be mirrored (or symmetrical) to each other.

Except for the difference described above, the semiconductor device according to the embodiments illustrated in FIG. 38 are substantially the same as the semiconductor device described with reference to FIGS. 4 to 6.

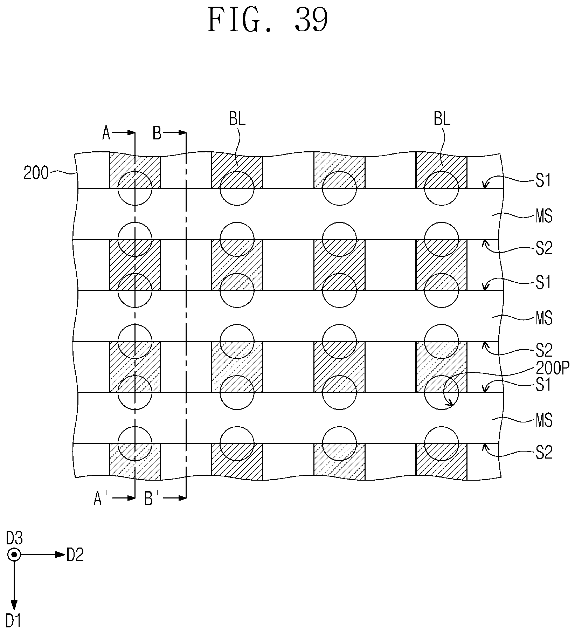

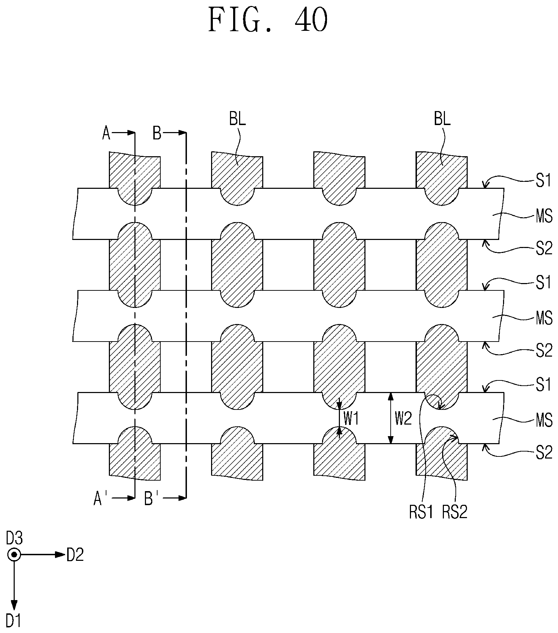

FIGS. 39 and 40 are plan views illustrating a method for manufacturing a semiconductor device according to some embodiments of the present disclosure. The cross-sectional views taken along A-A' and B-B' of FIG. 39 are substantially respectively the same as FIGS. 8 and 9, and the cross-sectional views taken along A-A' and B-B' of FIG. 40 are substantially respectively the same as FIGS. 11 and 12. In order to simplify description, a difference from the method for manufacturing a semiconductor device described with reference to FIGS. 7 to 22 will be mainly described.

Referring to FIGS. 8, 9, and 39, the bit lines BL may be formed on the substrate 100, and the insulating patterns 110 may be formed between the bit lines BL. The mold structures MS may be formed on the bit lines BL and the insulating patterns 110, and may cross the bit lines BL and the insulating patterns 110. Each of the mold structures MS may have the first side surface S1 and the second side surface S2 opposed to each other in the first direction D1.

A mask film 200 may be formed on the bit lines BL and the insulating patterns 110, and may cover or at least partially overlap the mold structures MS. The mask film 200 may have a plurality of openings 200P spaced apart from each other in the first direction D1 and the second direction D2. According to some embodiments, each of the plurality of openings 200P may have a circular shape, and may partially expose the mold structure MS, corresponding thereto, among the mold structures MS. Each of the plurality of openings 200P may expose the first side surface S1 or the second side surface S2 of the corresponding mold structure MS. A pair of openings 200P that are next or adjacent to each other in the first direction D1 among the plurality of openings 200P may respectively expose the first side surface S1 and the second side surface S2 of each of the mold structures MS. Openings 200P, in first columns, among the plurality of openings 200P may be spaced apart from each other in the second direction D2 along the first side surface S1 of each of the mold structures MS, and may expose the first side surface S1 of each of the mold structures MS. Openings 200P, in second columns, among the plurality of openings 200P may be spaced apart from each other in the second direction D2 along the second side surface S2 of each of the mold structures MS, and may expose the second side surface S2 of each of the mold structures MS.

Referring to FIGS. 11, 12, and 40, an etching process using the mask film 200 as an etching mask may be performed, and the portions of the mold structures MS exposed by the plurality of openings 200P may be etched by the etching process. Each of the mold structures MS may include the first part P1 having the first width W1, and the second part P2 having the second width W2 greater than the first width W1 by the etching process. The first part P1 of each of the mold structures MS may vertically (for example, in the third direction D3) overlap at least a portion of each of the bit lines BL, and the second part P2 of each of the mold structures MS may vertically (for example, in the third direction D3) overlap at least a portion of each of the insulating patterns 110 between the bit lines BL.

Each of the first side surface S1 and the second side surface S2 of each of the mold structures MS may have an uneven structure by the etching process. According to some embodiments, the first side surface S1 of each of the mold structures MS may have a first recessed side surface RS1 recessed from the first part P1 toward an inside of each of the mold structures MS (e.g., the first recessed side surface RS1 extends toward a center of the mold structure MS). Accordingly, the first part P1 of each of the mold structures MS may include a first recess region defined by the first recessed side surface RS1. The second side surface S2 of each of the mold structures MS may have a second recessed side surface RS2 recessed from the first part P1 toward the inside of each of the mold structures MS (e.g., the second recessed side surface RS2 extends toward a center of the mold structure MS). Accordingly, the first part P1 of each of the mold structures MS may include a second recess region defined by the second recessed side surface RS2. According to some embodiments, each of the first recessed side surface RS1 and the second recessed side surface RS2 may be a rounded side surface extending toward an inside of each of the mold structures MS. The first recessed side surface RS1 and the second recessed side surface RS2 may face away from each other in the first direction D1, and may be mirrored (or symmetrical) to each other.

The mask film 200 may be removed after the etching process. Thereafter, processes may be substantially performed in the same manner as the processes of the method for manufacturing a semiconductor device described with reference to FIGS. 4 to 6 and 13 to 22.

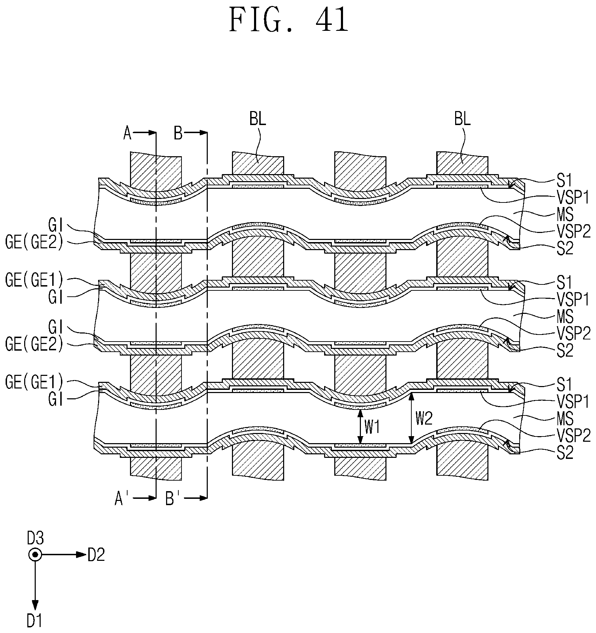

FIG. 41 is a plan view of a semiconductor device according to some embodiments of the present disclosure. The cross-sectional views taken along A-A' and B-B' of FIG. 41 are substantially respectively the same as FIGS. 5 and 6. In order to simplify description, the landing pad LP illustrated in FIGS. 4 and 23 is omitted. In order to simplify description, a difference from the semiconductor device described with reference to FIGS. 4 to 6 will be mainly described.

Referring to FIGS. 5, 6, and 41, the mold structures MS may be disposed on the bit lines BL and the insulating patterns 110, and may cross the bit lines BL and the insulating patterns 110. The mold structures MS may extend in the second direction D2, and may be spaced apart from each other in the first direction D1.

Each of the mold structures MS may include a first part P1 vertically (for example, in the third direction D3) overlapping at least a portion of each of the bit lines BL, and a second part P2 vertically (for example, in the third direction D3) overlapping at least a portion of each of the insulating patterns 110 between the bit lines BL. The first width W1 of the first part P1 may be different from the second width W2 of the second part P2. According to some embodiments, the first width W1 of the first part P1 may be smaller or less than the second width W2 of the second part P2.

Each of the mold structures MS may have the first side surface S1 and the second side surface S2 opposed to each other in the first direction D1. Each of the first side surface S1 and the second side surface S2 may have an uneven structure. According to some embodiments, the first side surface S1 of each of the mold structures MS may have a first recessed side surface RS1 recessed from the first part P1 vertically overlapping at least a portion of an odd-numbered bit line BL of the bit lines BL toward the inside of each of the mold structures MS. Accordingly, the first part P1 of each of the mold structures MS may include a first recess region defined by the first recessed side surface RS1. The second side surface S2 of each of the mold structures MS may have a second recessed side surface RS2 recessed from the first part P1 vertically overlapping at least a portion of an even-numbered bit line BL of the bit lines BL toward the inside of each of the mold structures MS. Accordingly, the first part P1 of each of the mold structures MS may include a second recess region defined by the second recessed side surface RS2. According to some embodiments, each of the mold structures MS may have a shape in which the first recessed side surface RS1 and the second recessed side surface RS2 are alternately arranged in the second direction D2.

The first vertical semiconductor pattern VSP1 and the second vertical semiconductor pattern VSP2 may be disposed on each of the bit lines BL, and may be spaced apart from each other in the first direction D1 with each of the mold structures MS therebetween. The first vertical semiconductor pattern VSP1 and the second vertical semiconductor pattern VSP2 may be spaced apart from each other in the first direction D1 with the first part P1 of each of the mold structures MS therebetween.

The first vertical semiconductor pattern VSP1 on the odd-numbered bit line BL of the bit lines BL may be disposed on the first recessed side surface RS1 of the first part P1, and may conformally extend along the first recessed side surface RS1. The first vertical semiconductor pattern VSP1 on the odd-numbered bit line BL may partially fill the first recess region. The second vertical semiconductor pattern VSP2 on the odd-numbered bit line BL may be disposed on the second side surface S2 of the first part P1. The first vertical semiconductor pattern VSP1 on the even-numbered bit line BL of the bit lines BL may be disposed on the first side surface S1 of the first part P1. The second vertical semiconductor pattern VSP2 on the even-numbered bit line BL may be disposed on the second recessed side surface RS2 of the first part P1, and may conformally extend along the second recessed side surface RS2. The second vertical semiconductor pattern VSP2 on the even-numbered bit line BL may partially fill the second recess region.

The horizontal semiconductor pattern HSP may be disposed on each of the bit lines BL, and between the mold structures MS. The horizontal semiconductor pattern HSP may be disposed between a pair of mold structures MS that are next or adjacent to each other among the mold structures MS. The horizontal semiconductor pattern HSP on the odd-numbered bit line BL may connect a lower portion of the first vertical semiconductor pattern VSP1 disposed on the first recessed side surface RS 1 of the first part P1 of one of the pair of mold structures MS, and a lower portion of the second vertical semiconductor pattern VSP2 disposed on the second side surface S2 of the first part P1 of the other of the pair of mold structures MS. The horizontal semiconductor pattern HSP on the even-numbered bit line BL may connect a lower portion of the first vertical semiconductor pattern VSP1 disposed on the first side surface S1 of the first part P1 of one of the pair of mold structures MS, and a lower portion of the second vertical semiconductor pattern VSP2 disposed on the second recessed side surface RS2 of the first part P1 of the other of the pair of mold structures MS.

Except for the difference described above, the semiconductor device according to the embodiments illustrated in FIG. 41 are substantially the same as the semiconductor device described with reference to FIGS. 4 to 6.

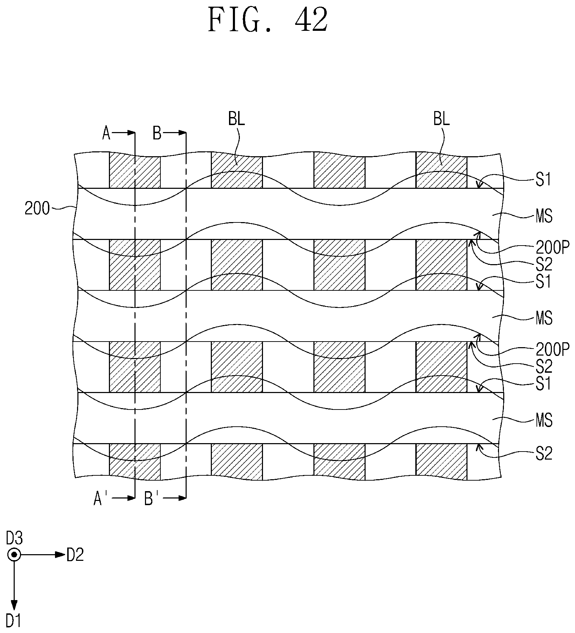

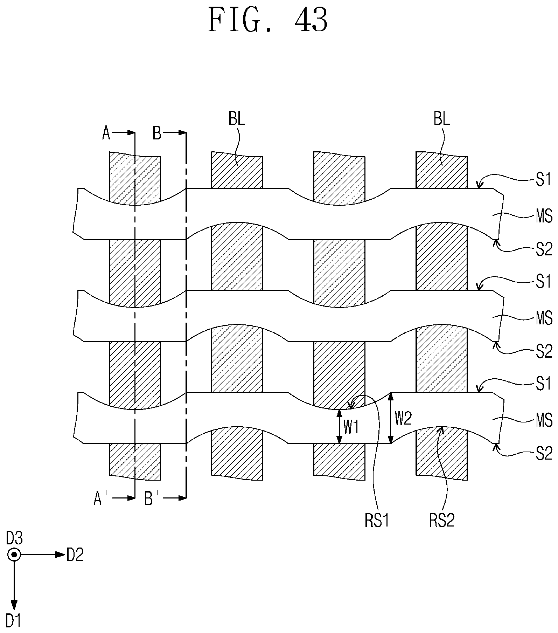

FIGS. 42 and 43 are plan views illustrating a method for manufacturing a semiconductor device according to some embodiments of the present disclosure. The cross-sectional views taken along A-A' and B-B' of FIG. 42 are substantially respectively the same as FIGS. 8 and 9 except for a shape of the opening 200P, and the cross-sectional views taken along A-A' and B-B' of FIG. 43 are substantially respectively the same as FIGS. 11 and 12. In order to simplify description, a difference from the method for manufacturing a semiconductor device described with reference to FIGS. 7 to 22 will be mainly described.

Referring to FIGS. 8, 9, and 42, the bit lines BL may be formed on the substrate 100, and the insulating patterns 110 may be formed between the bit lines BL. The mold structures MS may be formed on the bit lines BL and the insulating patterns 110, and may cross the bit lines BL and the insulating patterns 110. Each of the mold structures MS may have the first side surface S1 and the second side surface S2 opposed to each other in the first direction D1.

A mask film 200 may be formed on the bit lines BL and the insulating patterns 110, and may cover or at least partially overlap the mold structures MS. The mask film 200 may have a plurality of openings 200P spaced apart from each other in the first direction D1 and extending in the second direction D2. According to some embodiments, each of the plurality of openings 200P may have the nonlinear shape, such as a wave shape, extending in the second direction D2. Each of the plurality of openings 200P may be disposed between a pair of mold structures MS that are next or adjacent to each other among the mold structures MS in a plan view, and may alternately expose the first side surface S1 of one of the pair of mold structures MS and the second side surface S2 of the other of the pair of mold structures MS along the second direction D2.

Referring to FIGS. 11, 12, and 43, an etching process using the mask film 200 as an etching mask may be performed, and the portions of the mold structures MS exposed by the plurality of openings 200P may be etched by the etching process. Each of the mold structures MS may include the first part P1 having the first width W1, and the second part P2 having the second width W2 greater than the first width W1 by the etching process. The first part P1 of each of the mold structures MS may vertically (for example, in the third direction D3) overlap at least a portion of each of the bit lines BL, and the second part P2 of each of the mold structures MS may vertically (for example, in the third direction D3) overlap at least a portion of each of the insulating patterns 110 between the bit lines BL.

Each of the first side surface S1 and the second side surface S2 of each of the mold structures MS may have an uneven structure by the etching process. According to some embodiments, the first side surface S1 of each of the mold structures MS may have a first recessed side surface RS1 recessed from the first part P1 vertically overlapping at least a portion of an odd-numbered bit line BL of the bit lines BL toward the inside of each of the mold structures MS. Accordingly, the first part P1 of each of the mold structures MS may include a first recess region defined by the first recessed side surface RS1. The second side surface S2 of each of the mold structures MS may have a second recessed side surface RS2 recessed from the first part P1 vertically overlapping at least a portion of an even-numbered bit line BL of the bit lines BL toward the inside of each of the mold structures MS. Accordingly, the first part P1 of each of the mold structures MS may include a second recess region defined by the second recessed side surface RS2. According to some embodiments, each of the mold structures MS may have a shape in which the first recessed side surface RS1 and the second recessed side surface RS2 are alternately arranged in the second direction D2.

The mask film 200 may be removed after the etching process. Thereafter, processes may be substantially performed in the same manner as the processes of the method for manufacturing a semiconductor device described with reference to FIGS. 4 to 6 and 13 to 22.

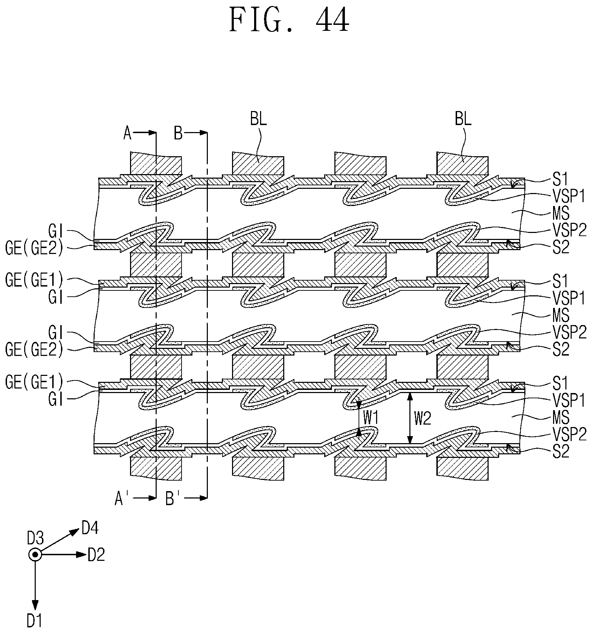

FIG. 44 is a plan view of a semiconductor device according to some embodiments of the present disclosure. The cross-sectional views taken along A-A' and B-B' of FIG. 44 are substantially respectively the same as FIGS. 5 and 6. In order to simplify description, the landing pad LP illustrated in FIGS. 4 and 23 is omitted. In order to simplify description, a difference from the semiconductor device described with reference to FIGS. 4 to 6 will be mainly described.

Referring to FIGS. 5, 6, and 44, the mold structures MS may be disposed on the bit lines BL and the insulating patterns 110, and may cross the bit lines BL and the insulating patterns 110. The mold structures MS may extend in the second direction D2, and may be spaced apart from each other in the first direction D1.

Each of the mold structures MS may include a first part P1 vertically (for example, in the third direction D3) overlapping at least a portion of each of the bit lines BL, and a second part P2 vertically (for example, in the third direction D3) overlapping at least a portion of each of the insulating patterns 110 between the bit lines BL. The first width W1 of the first part P1 may be different from the second width W2 of the second part P2. According to some embodiments, the first width W1 of the first part P1 may be smaller or less than the second width W2 of the second part P2.

Each of the mold structures MS may have the first side surface S1 and the second side surface S2 opposed to each other in the first direction D1. Each of the first side surface S1 and the second side surface S2 may have an uneven structure. According to some embodiments, the first side surface S1 of each of the mold structures MS may have a first recessed side surface RS1 recessed from the first part P1 toward an inside of each of the mold structures MS (e.g., the first recessed side surface RS 1 extends toward a center of the mold structure MS). Accordingly, the first part P1 of each of the mold structures MS may include a first recess region defined by the first recessed side surface RS1. The second side surface S2 of each of the mold structures MS may have a second recessed side surface RS2 recessed from the first part P1 toward the inside of each of the mold structures MS (e.g., the second recessed side surface RS2 extends toward a center of the mold structure MS). Accordingly, the first part P1 of each of the mold structures MS may include a second recess region defined by the second recessed side surface RS2.

According to some embodiments, the first recessed side surface RS1 may be a rounded side surface extending toward an inside of each of the mold structures MS, and a width along the second direction D2 of the first recess region may decrease in a direction getting closer to or approaching a center of each of the mold structures MS. The second recessed side surface RS2 may be a rounded side surface extending toward an inside of each of the mold structures MS, and a width along the second direction D2 of the second recess region may decrease in a direction getting closer to or approaching a center of each of the mold structures MS. The first recessed side surface RS1 and the second recessed side surface RS2 may face away from each other in the first direction D1, and may be asymmetrical.

Except for the difference described above, the semiconductor device according to the embodiments illustrated in FIG. 44 are substantially the same as the semiconductor device described with reference to FIGS. 4 to 6.

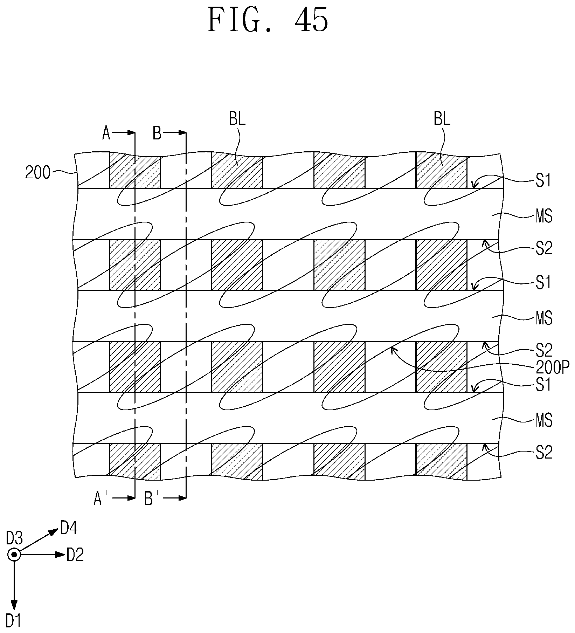

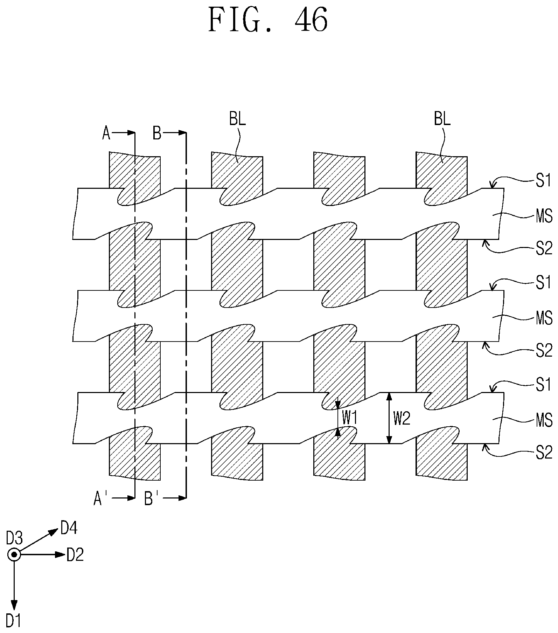

FIGS. 45 and 46 are plan views illustrating a method for manufacturing a semiconductor device according to some embodiments of the present disclosure. The cross-sectional views taken along A-A' and B-B' of FIG. 45 are substantially respectively the same as FIGS. 8 and 9 except for a shape of the opening 200P, and the cross-sectional views taken along A-A' and B-B' of FIG. 46 are substantially respectively the same as FIGS. 11 and 12. In order to simplify description, a difference from the method for manufacturing a semiconductor device described with reference to FIGS. 7 to 22 will be mainly described.

Referring to FIGS. 8, 9, and 45, the bit lines BL may be formed on the substrate 100, and the insulating patterns 110 may be formed between the bit lines BL. The mold structures MS may be formed on the bit lines BL and the insulating patterns 110, and may cross the bit lines BL and the insulating patterns 110. Each of the mold structures MS may have the first side surface S1 and the second side surface S2 opposed to each other in the first direction D1.

A mask film 200 may be formed on the bit lines BL and the insulating patterns 110, and may cover or at least partially overlap the mold structures MS. The mask film 200 may have a plurality of openings 200P spaced apart from each other in the first direction D1 and the second direction D2. According to some embodiments, each of the plurality of openings 200P may have a shape of an ellipse having a long axis parallel to the fourth direction D4. Each of the plurality of openings 200P may expose the portions of the pair of mold structures MS that are next to each other among the mold structures MS and an upper surface of an insulating pattern 110 between the pair of mold structures MS. That is, each of the plurality of openings 200P may expose the first side surface S1 of one of the pair of mold structures MS and the second side surface S2 of the other of the pair of the mold structures MS, and the upper surface of the insulating pattern 110 between the pair of mold structures MS.

Referring to FIGS. 11, 12, and 46, an etching process using the mask film 200 as an etching mask may be performed, and the portions of the mold structures MS exposed by the plurality of openings 200P may be etched by the etching process. Each of the mold structures MS may include the first part P1 having the first width W1, and the second part P2 having the second width W2 greater than the first width W1 by the etching process. The first part P1 of each of the mold structures MS may vertically (for example, in the third direction D3) overlap at least a portion of each of the bit lines BL, and the second part P2 of each of the mold structures MS may vertically (for example, in the third direction D3) overlap at least a portion of each of the insulating patterns 110 between the bit lines BL.

Each of the first side surface S1 and the second side surface S2 of each of the mold structures MS may have an uneven structure by the etching process. According to some embodiments, the first side surface S1 of each of the mold structures MS may have a first recessed side surface RS1 recessed from the first part P1 toward an inside of each of the mold structures MS (e.g., the first recessed side surface RS1 extends toward a center of the mold structure MS). Accordingly, the first part P1 of each of the mold structures MS may include a first recess region defined by the first recessed side surface RS1. The second side surface S2 of each of the mold structures MS may have a second recessed side surface RS2 recessed from the first part P1 toward the inside of each of the mold structures MS (e.g., the second recessed side surface RS2 extends toward a center of the mold structure MS). Accordingly, the first part P1 of each of the mold structures MS may include a second recess region defined by the second recessed side surface RS2.

According to some embodiments, the first recessed side surface RS1 may be a rounded side surface extending toward an inside of each of the mold structures MS, and a width along the second direction D2 of the first recess region may decrease in a direction getting closer to or approaching a center of each of the mold structures MS. The second recessed side surface RS2 may be a rounded side surface extending toward an inside of each of the mold structures MS, and a width along the second direction D2 of the second recess region may decrease in a direction getting closer to or approaching a center of each of the mold structures MS. The first recessed side surface RS1 and the second recessed side surface RS2 may face away from each other in the first direction D1, and may be asymmetrical.

The mask film 200 may be removed after the etching process. Thereafter, processes may be substantially performed in the same manner as the processes of the method for manufacturing a semiconductor device described with reference to FIGS. 4 to 6 and 13 to 22.

According to the present disclosure, a vertical semiconductor pattern may be disposed on one side surface of a mold structure, and may conformally extend along an uneven structure of the side surface of the mold structure. Accordingly, in a plan view, an area of the vertical semiconductor pattern may increase. As a result, a channel width of a vertical channel transistor using the vertical semiconductor pattern as a channel may increase, and thus operational characteristics of the vertical channel transistor may be improved.

In addition, since the area of the vertical semiconductor pattern increases, a contact area between the vertical semiconductor pattern and a node contact may increase. Accordingly, resistance between the vertical semiconductor pattern and the node contact may be reduced, and as a result, electrical characteristics of the vertical channel transistor may be improved.

Accordingly, a semiconductor device including vertical channel transistors, having the increased channel width, with the improved operational characteristics and electrical characteristics, and a method for manufacturing the same may be provided.

Although the embodiments of the present disclosure have been described, it is understood that the present disclosure should not be limited to these embodiments but various changes and modifications can be made by one ordinary skilled in the art within the scope of the present disclosure as hereinafter claimed.

## Claims

1. A semiconductor device comprising:
bit lines (BL) on a substrate (100), extending in a first direction (D1), and spaced apart from each other in a second direction (D2), the first direction (D1) and the second direction (D2) being parallel to an upper surface (100U) of the substrate (100) and crossing each other;
an insulating pattern (110) between the bit lines (BL) and extending in the first direction (D1);
a mold structure (MS) on the bit lines (BL) and the insulating pattern (110), extending in the second direction (D2), and comprising a first part (P1) at least partially overlapping each of the bit lines (BL) in a third direction (D3) perpendicular to the upper surface (100U) of the substrate (100) and a second part (P2) at least partially overlapping the insulating pattern (110) in the third direction (D3);
a first vertical semiconductor pattern (VSP1) and a second vertical semiconductor pattern (VSP2) on the bit lines (BL) and spaced apart from each other in the first direction (D1), the first part (P1) of the mold structure (MS) between the first vertical semiconductor pattern (VSP1) and the second vertical semiconductor pattern (VSP2); and
a first gate electrode (GE1) and a second gate electrode (GE2) spaced apart from each other in the first direction (D1) with the mold structure (MS) therebetween, the first gate electrode (GE1) and the second gate electrode (GE2) extending in the second direction (D2) and on the bit lines (BL) and the insulating pattern (110),
wherein the first vertical semiconductor pattern (VSP1) is between the first gate electrode (GE1) and the mold structure (MS),
wherein the second vertical semiconductor pattern (VSP2) is between the second gate electrode (GE2) and the mold structure (MS), and
wherein a first width (W1) in the first direction (D1) of the first part (P1) of the mold structure (MS) is different from a second width (W2) in the first direction (D1) of the second part (P2) of the mold structure (MS).

2. The semiconductor device of claim 1, wherein the first width (W1) is less than the second width (W2).

3. The semiconductor device of claim 2, wherein:
the first part (P1) of the mold structure (MS) comprises a first side surface (S1) and a second side surface (S2) opposed to each other in the first direction (D1),
the first side surface (S1) comprises a first recessed side surface (RS1) extending toward a center of the mold structure (MS), and
the second side surface (S2) comprises a second recessed side surface (RS2) extending toward the center of the mold structure (MS).

4. The semiconductor device of claim 3, wherein:
the first vertical semiconductor pattern (VSP1) extends along the first recessed side surface (RS1) of the first side surface (S1) of the mold structure (MS), and
the second vertical semiconductor pattern (VSP2) extends along the second recessed side surface (RS2) of the second side surface (S2) of the mold structure (MS).

5. The semiconductor device of any one of claims 2 to 4, further comprising a gate insulating pattern (GI) that is between the first gate electrode (GE1) and the first vertical semiconductor pattern (VSP1) and is between the second gate electrode (GE2) and the second vertical semiconductor pattern (VSP2).

6. The semiconductor device of claim 1, wherein the first width (W1) is greater than the second width (W2).

7. The semiconductor device of claim 6, wherein:
the first part (P1) of the mold structure (MS) comprises a first side surface (S1) and a second side surface (S2) opposed to each other in the first direction (D1),
the first side surface (S1) comprises a first protrusion side surface (PS 1) extending away from a center of the mold structure (MS), and
the second side surface (S2) comprises a second protrusion side surface (PS2) extending away from the center of the mold structure (MS).

8. The semiconductor device of claim 7, wherein:
the first vertical semiconductor pattern (VSP1) extends along the first protrusion side surface (PS1) of the first side surface (S1) of the mold structure (MS), and
the second vertical semiconductor pattern (VSP2) extends along the second protrusion side surface (PS2) of the second side surface (S2) of the mold structure (MS).

9. The semiconductor device of any one of claims 6 to 8, further comprising a gate insulating pattern (GI) that is between the first gate electrode (GE1) and the first vertical semiconductor pattern (VSP1) and is between the second gate electrode (GE2) and the second vertical semiconductor pattern (VSP2).

10. The semiconductor device of any preceding claim, wherein:
the mold structure (MS) comprises a first side surface (S1) and a second side surface (S2) opposed to each other in the first direction (D1),
the first vertical semiconductor pattern (VSP1) is between the first gate electrode (GE1) and the first side surface (S1) of the mold structure (MS),
the second vertical semiconductor pattern (VSP2) is between the second gate electrode (GE2) and the second side surface (S2) of the mold structure (MS), and
each of the first side surface (S1) and the second side surface (S2) has a nonlinear shape in the second direction (D2).
